# EUROPEAN PATENT APPLICATION

(11) **EP 4 404 708 A1**
(43) Date of publication of application: **24.07.2024**
(21) Application number: 23192930.8
(22) Date of filing: 23.08.2023
(51) Int. Cl.: H10B 12/00

(54) **SEMICONDUCTOR DEVICE AND A METHOD OF MANUFACTURING THE SAME**

(30) Priority: 19.01.2023 KR 20230008346
(71) Applicant: Samsung Electronics Co., Ltd., Suwon-si, Gyeonggi-do 16677 (KR)
(72) Inventor: LEE, Taeyoon, Suwon-si, Gyeonggi-do 16677 (KR); KIM, Junsoo, Suwon-si, Gyeonggi-do 16677 (KR); MOON, Daehyun, Suwon-si, Gyeonggi-do 16677 (KR)
(74) Representative: Kuhnen & Wacker Patent- und Rechtsanwaltsbüro PartG mbB

(57) **Abstract**

A semiconductor device includes an active pattern extending along a first direction, and first and second word lines intersecting the active pattern. The active pattern includes a center active portion between the first and second word lines. The center active portion includes a center portion extending from the first word line to the second word line, a first center protrusion protruding from one side surface of the center portion in a second direction intersecting the first direction, and a second center protrusion protruding from another side surface of the center portion in an opposite direction to the second direction. The first center protrusion extends from the first word line along the first direction. The second center protrusion extends from the second word line along an opposite direction to the first direction.

## Description

### CROSS-REFERENCE TO RELATED APPLICATIONS

This U.S. non-provisional patent application claims priority under 35 U.S.C. §119 to Korean Patent Application No. 10-2023-0008346, filed on January 19, 2023, in the Korean Intellectual Property Office, the entire contents of which are hereby incorporated by reference.

### BACKGROUND

Various example embodiments relate to a semiconductor device and.ir a method of manufacturing the same.

Semiconductor devices are widely used in an electronic industry because of their small sizes, multi-functional characteristics, and/or low manufacturing costs. Semiconductor devices may be categorized as any one or more of semiconductor memory devices for storing logical data, semiconductor logic devices for processing logical data, and hybrid semiconductor devices having both the function of the semiconductor memory devices and the function of the semiconductor logic devices.

High-speed and low-voltage semiconductor devices have been desired or demanded to satisfy characteristics (e.g., high speed and/or low power consumption) of electronic devices including semiconductor devices. Semiconductor devices have been highly integrated to at least partly meet these demands. However, electrical characteristics and/or reliability of semiconductor devices may be deteriorated due to the high integration density of the semiconductor devices. Thus, techniques for improving electrical characteristics and reliability of semiconductor devices have been variously studied.

### SUMMARY

Various example embodiments may provide a semiconductor device with improved electrical characteristics and reliability, and/or a method of manufacturing the same.

Alternatively or additionally, various example embodiments may also provide a semiconductor device with improved productivity, and a method of manufacturing the same.

In some example embodiments, a semiconductor device may include an active pattern extending along a first direction with a first word line and a second word line that are defined to intersect the active pattern. The active pattern may include a center active portion between the first word line and the second word line. The center active portion may include a center portion extending from the first word line to the second word line; a first center protrusion protruding from one side surface of the center portion in a second direction intersecting the first direction; and a second center protrusion protruding from another side surface of the center portion in an opposite direction to the second direction. The first center protrusion may extend from the first word line along the first direction. The second center protrusion may extend from the second word line along an opposite direction to the first direction.

Alternatively or additionally according to some example embodiments, a semiconductor device may include active patterns, each of which extends along a first direction; and a device isolation pattern surrounding each of the active patterns. The active patterns may include a first active pattern; a second active pattern spaced apart from the first active pattern in the first direction; a third active pattern spaced apart from the first and second active patterns in a second direction intersecting the first direction; and a fourth active pattern spaced apart from the first and second active patterns in an opposite direction to the second direction. The device isolation pattern may include first device isolation patterns between the first active pattern and the third active pattern and between the second active pattern and the fourth active pattern; and second device isolation patterns between the first active pattern and the fourth active pattern and between the second active pattern and the third active pattern. Each of the first device isolation patterns and the second device isolation patterns may protrude from a side surface of an adjacent active pattern toward an inside of the adjacent active pattern.

Alternatively or additionally according to some example embodiments, a semiconductor device may include a substrate; an active pattern on the substrate and extending along a first direction parallel to a bottom surface of the substrate, the active pattern comprising a first edge active portion, a second edge active portion, and a center active portion between the first and second edge active portions; a device isolation pattern surrounding the active pattern; a first word line intersecting the active pattern between the first edge active portion and the center active portion; a second word line intersecting the active pattern between the second edge active portion and the center active portion; a bit line extending on the active pattern and electrically connected to the center active portion; storage node contacts electrically connected to the first edge active portion and the second edge active portion, respectively; and data storage patterns electrically connected to the storage node contacts, respectively. The center active portion may include a center portion; a first center protrusion protruding from the center portion in a second direction which is parallel to the bottom surface of the substrate and intersects the first direction; and a second center protrusion protruding from the center portion in an opposite direction to the second direction. The first center protrusion may extend from the first word line along the first direction. The second center protrusion may extend from the second word line along an opposite direction to the first direction.

Alternatively or additionally according to some example embodiments, a method of manufacturing a semiconductor device may include etching a substrate to form active patterns extending along a first direction and an active trench region between the active patterns, the active trench region having a narrow trench region and a wide trench region; forming a sacrificial layer covering the active patterns and an inner surface of the active trench region; removing the sacrificial layer in the wide trench region to expose portions of the active patterns; and forming protrusions on the exposed portions of the active patterns. The sacrificial layer may completely fill the narrow trench region in the forming of the sacrificial layer.

### BRIEF DESCRIPTION OF THE DRAWINGS

FIG. 1 is a plan view illustrating a semiconductor device according to some example embodiments of inventive concepts.
FIGS. 2A and 2B are cross-sectional views taken along lines A-A' and B-B' of FIG. 1, respectively, to illustrate a semiconductor device according to some example embodiments of inventive concepts.
FIGS. 3A and 4A are enlarged views corresponding to a region 'P1' of FIG. 1 at a level higher than a first level of FIG. 2A and a level lower than the first level of FIG. 2A, respectively.
FIGS. 3B and 4B are enlarged views of active patterns of FIGS. 3A and 4A, respectively.
FIG. 5 is a cross-sectional view corresponding to the line A-A' of FIG. 1 to illustrate a semiconductor device according to some example embodiments of inventive concepts.
FIG. 6 is a cross-sectional view corresponding to the line B-B' of FIG. 1 to illustrate a semiconductor device according to some example embodiments of inventive concepts.
FIG. 7A is an enlarged view corresponding to the region 'P1' of FIG. 1 at a level lower than the first level of FIG. 2A.
FIG. 7B is an enlarged view of an active pattern of FIG. 7A.
FIGS. 8 to 19B are views illustrating a method of manufacturing a semiconductor device according to some example embodiments of inventive concepts.
FIG. 20 is a view illustrating a method of manufacturing a semiconductor device according to some example embodiments of inventive concepts.
FIGS. 21 to 26B are views illustrating a method of manufacturing a semiconductor device according to some example embodiments of inventive concepts.

### DETAILED DESCRIPTION

Various example embodiments will now be described more fully with reference to the accompanying drawings.

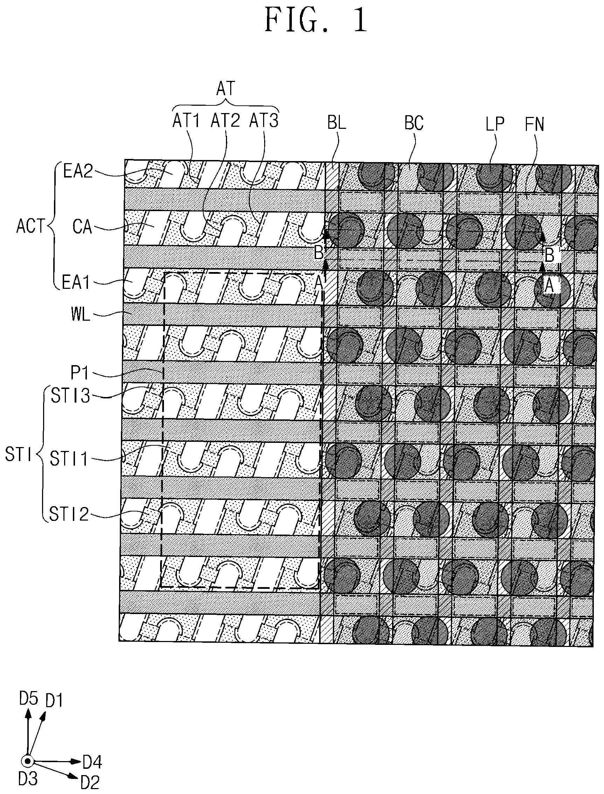

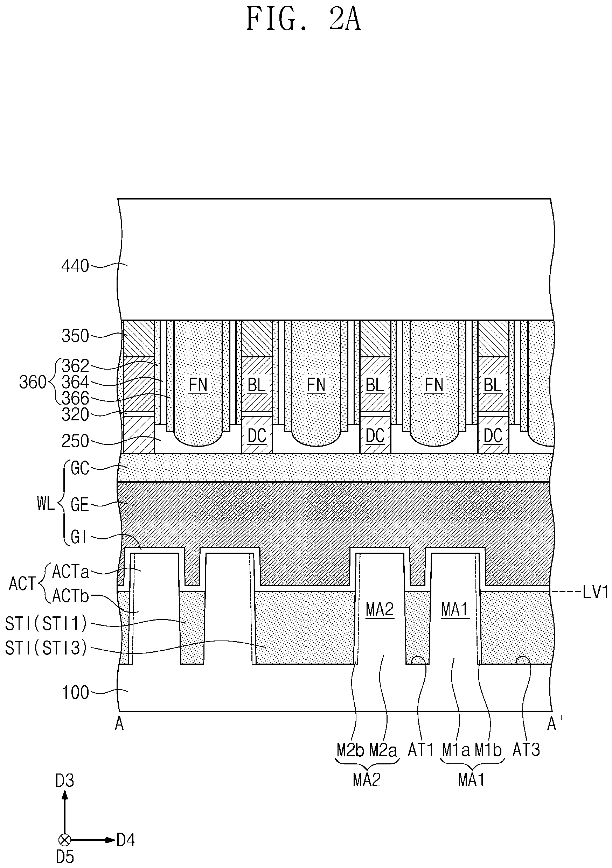

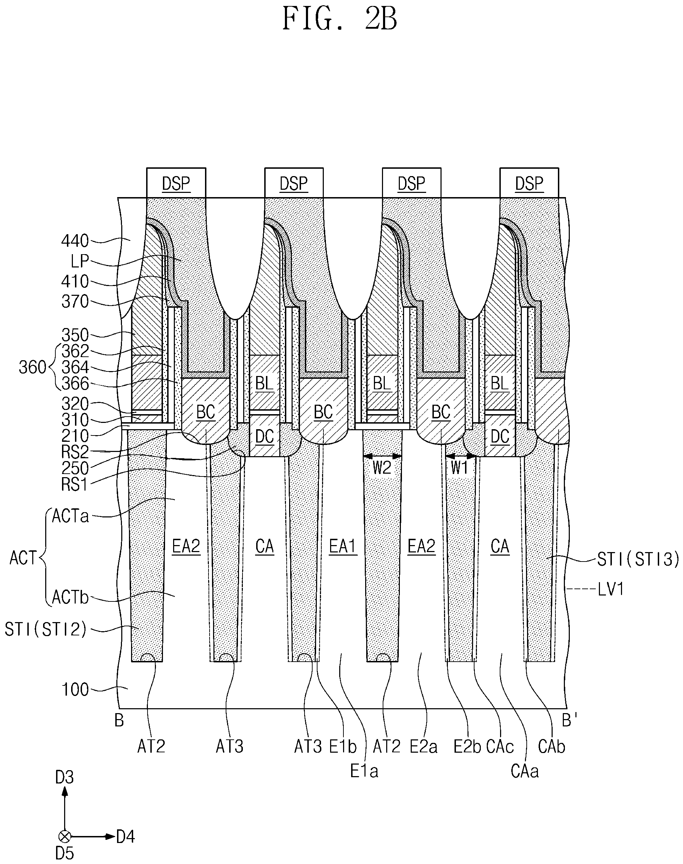

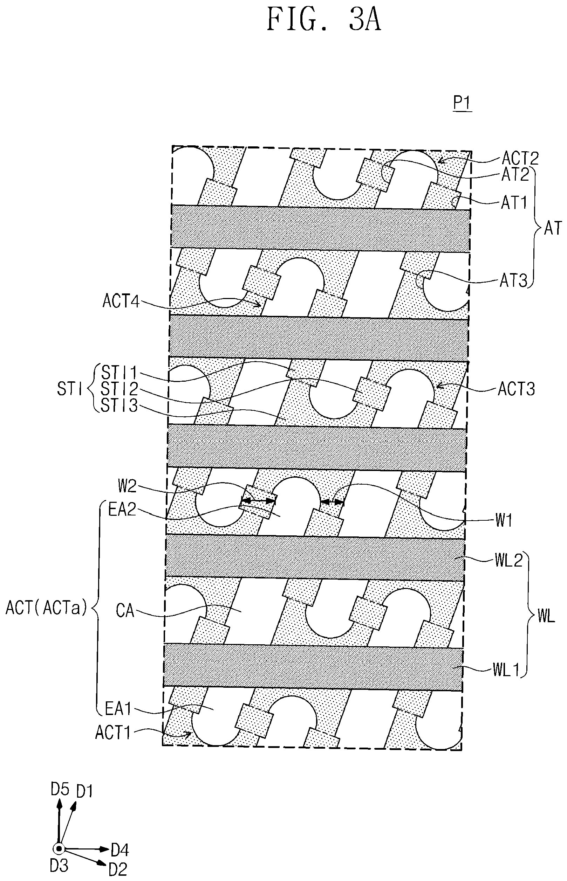

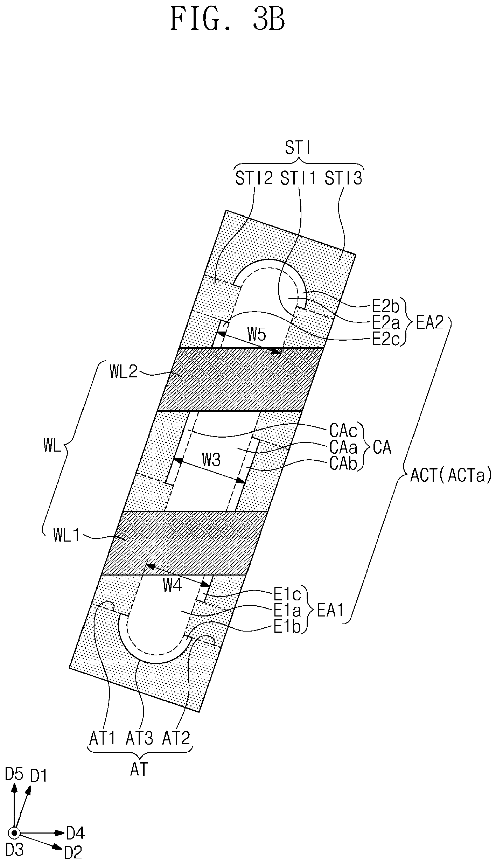

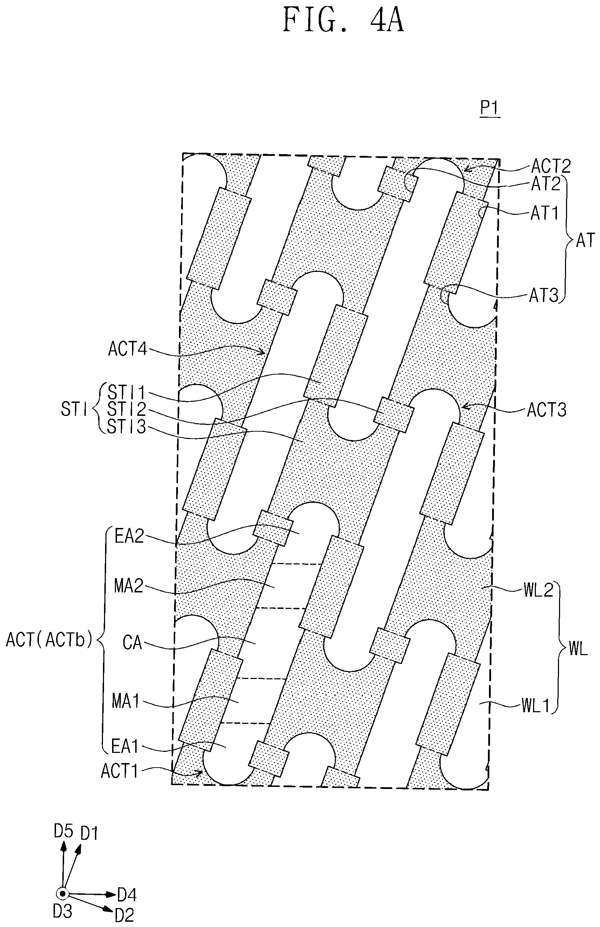

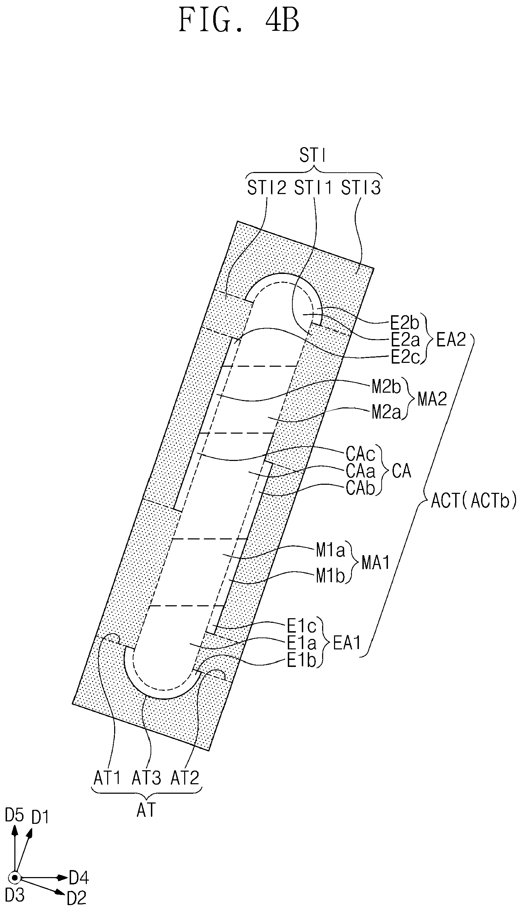

FIG. 1 is a plan view illustrating a semiconductor device according to some example embodiments of inventive concepts. FIGS. 2A and 2B are cross-sectional views taken along lines A-A' and B-B' of FIG. 1, respectively, to illustrate a semiconductor device according to some example embodiments of inventive concepts. FIGS. 3A and 4A are enlarged views corresponding to a region 'P1' of FIG. 1 at a level higher than a first level of FIG. 2A and a level lower than the first level of FIG. 2A, respectively. FIGS. 3B and 4B are enlarged views of active patterns of FIGS. 3A and 4A, respectively.

To aid understanding of inventive concepts, an active pattern ACT to be described later and components located below the active pattern ACT are illustrated in a left region of FIG. 1, but components located on and above the active pattern ACT are omitted in the left region of FIG. 1. Thus, even though not shown in FIG. 1, as in a right region of FIG. 1, components located on and above the active pattern ACT to be described later are also provided in the left region of FIG. 1.

Referring to FIGS. 1 to 2B, a substrate 100 may be provided. The substrate 100 may be or may include a semiconductor substrate (e.g., a silicon substrate and/or a silicon-on-insulator (SOI) substrate).

A device isolation pattern STI may be disposed in the substrate 100 and may define an active pattern ACT. The active pattern ACT may be provided in plurality. For example, the active patterns ACT may include portions of the substrate 100, which are surrounded by the device isolation pattern STI. As used herein, the substrate 100 may be defined as another portion of the substrate 100 except the portions of the substrate 100 unless otherwise stated, for the purpose of ease and convenience in explanation.

The active patterns ACT may be spaced apart from each other in a first direction D1 and a second direction D2. The first direction D1 and the second direction D2 may be parallel to a bottom surface of the substrate 100 and may intersect (e.g., be perpendicular to) each other. Each of the active patterns ACT may have a long shape extending along the first direction D1. Each of the active patterns ACT may have a shape protruding in a third direction D3 perpendicular to the bottom surface of the substrate 100. The active pattern ACT may include the same material (e.g., silicon such as single-crystal silicon) as the substrate 100. The first direction D1 and the second direction D2 may not be parallel to a crystal axis of the substrate 100; however, example embodiments are not limited thereto.

The active pattern ACT may include a first edge active portion EA1, a second edge active portion EA2 spaced apart from the first edge active portion EA1 in the first direction D1, and a center active portion CA between the first and second edge active portions EA1 and EA2. The first edge active portion EA1 and the second edge active portion EA2 may be both end portions of the active pattern ACT in the first direction D1. The center active portion CA may be disposed between word lines WL to be described later, which intersect the active pattern ACT. Dopants (e.g., n-type dopants such as phosphorus and/or arsenic, and/or p-type dopants such as boron, and/or Group IV dopants such as carbon and/or germanium) may be provided in the first and second edge active portions EA1 and EA2 and the center active portion CA.

The device isolation pattern STI may include an insulating material and may include at least one of, for example, silicon oxide, silicon nitride, or a combination thereof. The device isolation pattern STI may be a single layer formed of a single material or a composite layer including two or more materials. As used herein, the term `A or B', `at least one of A and B', `at least one of A or B', `A, B or C', `at least one of A, B and C', or `at least one of A, B, or C' may include any and all combinations of one or more of the associated listed items.

A row line or a word line WL may intersect the active patterns ACT. The word line WL may be provided in plurality. The word lines WL may extend along a fourth direction D4 and may be spaced apart from each other in a fifth direction D5. Each of the fourth direction D4 and the fifth direction D5 may be parallel to the bottom surface of the substrate 100 and may intersect the first and second directions D1 and D2. Alternatively or additionally, the fourth and fifth directions D4 and D5 may be orthogonal to each other; however, example embodiments are not limited thereto. The word lines WL may be buried or disposed in trenches provided in the active patterns ACT and the device isolation pattern STI. For example, a pair of the word lines WL adjacent to each other in the fifth direction D5 may intersect one active pattern ACT.

Each of the word lines WL may include a gate electrode GE, a gate dielectric pattern GI, and a gate capping pattern GC. The gate electrode GE may penetrate the active patterns ACT and the device isolation pattern STI in the fourth direction D4. The gate dielectric pattern GI may be disposed between the gate electrode GE and the active patterns ACT and between the gate electrode GE and the device isolation pattern STI. The gate capping pattern GC may be disposed on the gate electrode GE to cover a top surface of the gate electrode GE. For example, the gate electrode GE may include a conductive material such as but not limited to doped polysilicon and/or a metal such as tungsten and/or titanium. In some example embodiments, the gate dielectric pattern GI may include at least one of silicon oxide or a high-k dielectric material. In some example embodiments, the gate capping pattern GC may include silicon nitride.

A bottommost surface of the word line WL may be located at a first level LV1. Each of the active patterns ACT may include an upper active pattern ACTa defined at a level higher than the first level LV1, and a lower active pattern ACTb defined at a level lower than the first level LV1.

A buffer pattern 210 may be disposed on the substrate 100. The buffer pattern 210 may cover the active patterns ACT, the device isolation pattern STI, and the word lines WL. For example, the buffer pattern 210 may include at least one of silicon oxide, silicon nitride, silicon oxynitride, or any combination thereof. The buffer pattern 210 may be a single layer formed of (or consisting of or essentially of) a single material or a composite layer including two or more materials.

A bit line contact DC may be provided on each of the active patterns ACT and may be provided in plurality. The bit line contacts DC may be electrically connected to the center active portions CA of the active patterns ACT, respectively. The bit line contacts DC may be spaced apart from each other in the fourth and fifth directions D4 and D5. The bit line contacts DC may be disposed between the active patterns ACT and column lines or bit lines BL to be described later. Each of the bit line contacts DC may electrically connect a corresponding one of the bit lines BL to the center active portion CA of a corresponding one of the active patterns ACT.

The bit line contacts DC may be disposed in first recess regions RS1, respectively. The first recess regions RS1 may be provided in upper portions of the active patterns ACT and an upper portion of the device isolation pattern STI adjacent to the upper portions of the active patterns ACT. The first recess regions RS 1 may be spaced apart from each other in the fourth and fifth directions D4 and D5.

A filling insulation pattern 250 may fill each of the first recess regions RS1. The filling insulation pattern 250 may fill the inside of the first recess region RS1. For example, the filling insulation pattern 250 may cover an inner surface of the first recess region RS1, and at least a portion of a side surface of the bit line contact DC (e.g., at least a portion of the side surface of the bit line contact DC in the first recess region RS1). The filling insulation pattern 250 may include at least one of silicon oxide, silicon nitride, or a combination thereof. The filling insulation pattern 250 may be a single layer formed of a single material (or consisting of a single material) or a composite layer including two or more materials.

The bit line BL may be provided on the bit line contact DC. The bit line BL may extend along the fifth direction D5, and may be perpendicular to the word line WL. The bit line BL may be disposed on the bit line contacts DC arranged in a line in the fifth direction D5. The bit line BL may be provided in plurality. The bit lines BL may be spaced apart from each other in the fourth direction D4. The bit line BL may include a metal material. For example, the bit line BL may include at least one of tungsten, rubidium, molybdenum, titanium, or any combination thereof.

A polysilicon pattern 310 may be provided between the bit line BL and the buffer pattern 210. The polysilicon pattern 310 may be provided in plurality. For example, the plurality of polysilicon patterns 310 may be spaced apart from each other in the fourth direction D4 and the fifth direction D5. A top surface of the polysilicon pattern 310 may be located at substantially the same height as a top surface of the bit line contact DC and may be substantially coplanar with the top surface of the bit line contact DC. The polysilicon pattern 310 may include polysilicon doped with dopants such as but not limited to boron.

A first ohmic pattern 320 may be disposed between the bit line BL and the bit line contact DC and between the bit line BL and the polysilicon pattern 310. The first ohmic pattern 320 may extend along the fifth direction D5 along the bit line BL. The first ohmic pattern 320 may be provided in plurality. The plurality of first ohmic patterns 320 may be spaced apart from each other in the fourth direction D4. The first ohmic pattern 320 may include a metal silicide. A first barrier pattern (not shown) may be further disposed between the bit line BL and the bit line contact DC and between the bit line BL and the polysilicon pattern 310. The first barrier pattern may include a conductive metal nitride such as titanium nitride and/or tantalum nitride.

A bit line capping pattern 350 may be provided on a top surface of the bit line BL. The bit line capping pattern 350 may extend along the fifth direction D5 on the top surface of the bit line BL. The bit line capping pattern 350 may be provided in plurality. The plurality of bit line capping patterns 350 may be spaced apart from each other in the fourth direction D4. The bit line capping pattern 350 may vertically overlap with the bit line BL. The bit line capping pattern 350 may be or may be formed of a single layer or a plurality of layers. For example, the bit line capping pattern 350 may include a first capping pattern, a second capping pattern and a third capping pattern, which are sequentially stacked. All or at least one of the first to third capping patterns may include silicon nitride. Alternatively, the bit line capping pattern 350 may include four or more stacked capping patterns.

A bit line spacer 360 may be provided on a side surface of the bit line BL and a side surface of the bit line capping pattern 350. The bit line spacer 360 may cover the side surface of the bit line BL and the side surface of the bit line capping pattern 350. The bit line spacer 360 may extend along the fifth direction D5 on the side surface of the bit line BL. The bit line spacer 360 may include an air gap; however, example embodiments are not limited thereto.

The bit line spacer 360 may include a plurality of spacers. For example, the bit line spacer 360 may include a first spacer 362, a second spacer 364, and a third spacer 366. The third spacer 366 may be provided on the side surface of the bit line BL and the side surface of the bit line capping pattern 350. The first spacer 362 may be disposed between the bit line BL and the third spacer 366 and between the bit line capping pattern 350 and the third spacer 366. The second spacer 364 may be disposed between the first spacer 362 and the third spacer 366. For example, the first to third spacers 362, 364 and 366 may each independently include at least one of silicon nitride, silicon oxide, silicon oxynitride, or a combination thereof. Alternatively or additionally, the second spacer 364 may include an air gap separating the first and third spacers 362 and 366 from each other.

A capping spacer 370 may be located on the bit line spacer 360. The capping spacer 370 may cover an upper portion of a side surface of the bit line spacer 360. For example, the capping spacer 370 may include silicon nitride.

A storage node contact BC may be provided between the bit lines BL adjacent to each other. For example, the storage node contact BC may be disposed between the bit line spacers 360 adjacent to each other. The storage node contact BC may be provided in plurality. The plurality of storage node contacts BC may be spaced apart from each other in the fourth and fifth directions D4 and D5. The storage node contacts BC may be spaced apart from each other in the fifth direction D5 by a fence pattern FN provided on the word line WL. The fence pattern FN may be provided between the bit lines BL adj acent to each other. The fence pattern FN may be provided in plurality. The fence patterns FN may be spaced apart from each other in the fourth and fifth directions D4 and D5. The fence patterns FN adjacent to each other in the fourth direction D4 may be spaced apart from each other with the bit line BL interposed therebetween. The fence patterns FN adjacent to each other in the fifth direction D5 may be spaced apart from each other with the storage node contact BC interposed therebetween. In some example embodiments, the fence patterns FN may include silicon nitride.

The storage node contacts BC may fill second recess regions RS2 provided on the first edge active portion EA1 and the second edge active portion EA2 of the active pattern ACT, respectively. Each of the storage node contacts BC may be electrically connected to a corresponding one of the first and second edge active portions EA1 and EA2. The storage node contact BC may include at least one of polysilicon doped with dopants, undoped polysilicon, a metal material, or any combination thereof.

A second barrier pattern 410 may cover, e.g. may conformally cover the bit line spacer 360, the fence pattern FN, and the storage node contact BC. The second barrier pattern 410 may include a metal nitride such as titanium nitride and/or tantalum nitride. A second ohmic pattern (not shown) may be disposed between the second barrier pattern 410 and the storage node contact BC. The second ohmic pattern may include a metal silicide.

A landing pad LP may be provided on the storage node contact BC. The landing pad LP may be provided in plurality. The plurality of landing pads LP may be spaced apart from each other in the fourth and fifth directions D4 and D5. Each of the landing pads LP may be connected to a corresponding one of the storage node contacts BC. The landing pad LP may cover a top surface of the bit line capping pattern 350. A lower region of the landing pad LP may vertically overlap with the storage node contact BC. An upper region of the landing pad LP may be shifted from the lower region in the fourth direction D4. The landing pad LP may include a metal material such as at least one of tungsten, titanium, or tantalum.

A filling pattern 440 may surround the landing pad LP when viewed in a plan view. The filling pattern 440 may be disposed between the landing pads LP adjacent to each other. The filling pattern 440 may have a mesh shape including holes (such as circular or elliptical or polygonal holes) penetrated by the landing pads LP, when viewed in a plan view. For example, the filling pattern 440 may include at least one of silicon nitride, silicon oxide, silicon oxynitride, or any combination thereof. Alternatively, the filling pattern 440 may include an empty space (e.g., an air gap) including air.

A data storage pattern DSP may be provided on the landing pad LP. The data storage pattern DSP may be provided in plurality. The plurality of data storage patterns DSP may be spaced apart from each other in the fourth and fifth directions D4 and D5. Each of the data storage patterns DSP may be electrically connected to a corresponding one of the first and second edge active portions EA1 and EA2 through a corresponding one of the landing pads LP and a corresponding one of the storage node contacts BC.

In some example embodiments, the data storage pattern DSP may be or may include a capacitor including a lower electrode, a dielectric layer and an upper electrode. In this case, the semiconductor device according to inventive concepts may be or may include a dynamic random access memory (DRAM) device. For certain examples, the data storage pattern DSP may include a magnetic tunnel junction pattern. In this case, the semiconductor device according to inventive concepts may be or may include a magnetic random access memory (MRAM) device. For certain examples, the data storage pattern DSP may include a phase-change material or a variable resistance material. In this case, the semiconductor device according to inventive concepts may be or may include a phase-change random access memory (PRAM) device or a resistive random access memory (ReRAM) device. However, embodiments of inventive concepts are not limited thereto, and in certain example embodiments, the data storage pattern DSP may include at least one of other various structures and/or materials capable of storing data.

Hereinafter, structures of the active pattern ACT, the device isolation pattern STI and the word line WL of the semiconductor device according to some example embodiments of inventive concepts will be described in more detail with reference to FIGS. 3A to 4B.

Referring to FIGS. 2A to 4B, for example, the active patterns ACT may include a first active pattern ACT1, a second active pattern ACT2, a third active pattern ACT3, and a fourth active pattern ACT4. The second active pattern ACT2 may be spaced apart from the first active pattern ACT1 in the first direction D1. The third active pattern ACT3 may be spaced apart from the first and second active patterns ACT1 and ACT2 in the second direction D2. The fourth active pattern ACT4 may be spaced apart from the first and second active patterns ACT1 and ACT2 (or the third active pattern ACT3) in an opposite direction to the second direction D2. For example, the first active pattern ACT1, the third active pattern ACT3, the second active pattern ACT2 and the fourth active pattern ACT4 may be sequentially arranged in a counter-clockwise direction. An arrangement shape of the active patterns ACT may be a shape in which the arrangement shape of the first to fourth active patterns ACT1, ACT2, ACT3 and ACT4 is repeated.

An active trench region AT may be provided between the active patterns ACT, and the device isolation pattern STI may fill the active trench region AT. In some example embodiments, the device isolation pattern STI may include first device isolation patterns STI1, second device isolation patterns STI2, and third device isolation patterns STI3, and the first to third device isolation patterns STI1, STI2 and STI3 may fill a first narrow trench region AT1, a second narrow trench region AT2 and a wide trench region AT3, respectively.

In some example embodiments, the first narrow trench regions AT1 may be defined between the first active pattern ACT1 and the third active pattern ACT3 and between the second active pattern ACT2 and the fourth active pattern ACT4, and the first device isolation patterns STI1 may fill the first narrow trench regions AT1. In some example embodiments, the second narrow trench regions AT2 may be defined between the first active pattern ACT1 and the fourth active pattern ACT4 and between the second active pattern ACT2 and the third active pattern ACT3, and the second device isolation patterns STI2 may fill the second narrow trench regions AT2. In some example embodiments, the wide trench region AT3 may be defined in a region surrounded by the first to fourth active patterns ACT1, ACT2, ACT3 and ACT4 and the first and second device isolation patterns STI1 and STI2, and the third device isolation pattern STI3 may fill the wide trench region AT3. Since the arrangement shape of the first to fourth active patterns ACT1, ACT2, ACT3 and ACT4 is repeated, an arrangement shape of the first to third device isolation patterns STI1, STI2 and STI3 may also be repeated therebetween.

The first device isolation pattern STI1 and the second device isolation pattern STI2 may include the same material, e.g., may not include any different material. In some example embodiments, the first and second device isolation patterns STI1 and STI2 may be formed at the same time as each other. For example, each of the first device isolation pattern STI1 and the second device isolation pattern STI2 may include at least one of silicon oxide (SiO₂), silicon nitride ( Si₃N₄), aluminum oxide (Al₂O₃), lanthanum oxide (La₂O₃), aluminum nitride (AlN), or silicon oxynitride (SiON). The third device isolation pattern STI3 may include the same material as or a different material from that of the first device isolation pattern STI1 and the second device isolation pattern STI2, and may or may not have a common material. For example, the third device isolation pattern STI3 may include at least one of SiO₂ or SiN, which may or may not be included in the first device isolation pattern STI1 and/or the second device isolation pattern STI2. Each of the first to third device isolation patterns STI1, STI2 and STI3 may independently or jointly be a single layer formed of a single material or a composite layer including two or more materials. In some example embodiments, the first to third device isolation patterns STI1, STI2 and STI3 may be in contact with each other without interfaces therebetween. In certain example embodiments, the first to third device isolation patterns STI1, STI2 and STI3 may be in contact with each other with interfaces therebetween.

Each of the first device isolation patterns STI1 and the second device isolation patterns STI2 may protrude from a side surface of the active pattern ACT adjacent thereto toward the inside of the adjacent active pattern ACT. For example, one first device isolation pattern STI1 and one second device isolation pattern STI2 may be disposed adjacent to one side surface of one active pattern ACT. Each of the first device isolation pattern STI1 and the second device isolation pattern STI2 may protrude from the one side surface of the active pattern ACT toward the inside of the active pattern ACT. In certain example embodiments, another first device isolation pattern STI1 and another second device isolation pattern STI2 may be disposed adjacent to another side surface of the active pattern ACT. Each of the other first device isolation pattern STI1 and the other second device isolation pattern STI2 may protrude from the other side surface of the active pattern ACT toward the inside of the active pattern ACT. A length of the first device isolation pattern STI1 in the first direction D1 may be greater than a length of the second device isolation pattern STI2 in the first direction D1. The third device isolation pattern STI3 may not protrude toward the inside of the active pattern ACT adjacent thereto.

Since the first device isolation pattern STI1 and the second device isolation pattern STI2 protrude toward the inside of the active pattern ACT, the active pattern ACT may have protrusions protruding toward the outside. Thus, a profile of each of the side surfaces of the active pattern ACT may have an uneven shape. A thickness of the protrusion of the active pattern ACT may be greater than 0nm and may be equal to or less than 5 nm. The protrusions of the active pattern ACT may include silicon. For example, the protrusions of the active pattern ACT may include at least one of single-crystalline silicon or polysilicon, and may or may not be doped with impurities. Hereinafter, features of the protrusions in the upper active pattern ACTa and the lower active pattern ACTb will be described in detail.

Referring to FIGS. 3A and 3B, a pair of the word lines WL may intersect the active pattern ACT (in particular, the upper active pattern ACTa of the active pattern ACT) in the fourth direction D4. For example, a first word line WL1 and a second word line WL2 may intersect the active pattern ACT. The first word line WL 1 may be disposed between the center active portion CA and the first edge active portion EA1 of the active pattern ACT to separate them CA and EA1 from each other. The second word line WL2 may be disposed between the center active portion CA and the second edge active portion EA2 of the active pattern ACT to separate them CA and EA2 from each other. For example, the first word line WL1 may intersect one of the first device isolation patterns STI1, and the second word line WL2 may intersect another of the first device isolation patterns STI1. In certain example embodiments, each of the first word line WL1 and the second word line WL2 may alternately intersect the first device isolation patterns STI1 and the third device isolation patterns STI3.

The center active portion CA may include a center portion CAa, a first center protrusion CAb, and a second center protrusion CAc.

The center portion CAa may extend from the first word line WL1 to the second word line WL2. For example, the center portion CAa may extend from the first word line WL1 to the second word line WL2 along the first direction D1.

The first center protrusion CAb may protrude from one side surface of the center portion CAa in the second direction D2. The first center protrusion CAb may extend from the first word line WL1 along the first direction D1. The first center protrusion CAb may be spaced apart from the second word line WL2. For example, the first center protrusion CAb may be spaced apart from the second word line WL2 with the device isolation pattern STI (e.g., the first device isolation pattern STI1) interposed therebetween.

The second center protrusion CAc may protrude from another side surface of the center portion CAa in the opposite direction to the second direction D2. The second center protrusion CAc may extend from the second word line WL2 along an opposite direction to the first direction D1. The second center protrusion CAc may be spaced apart from the first word line WL1. For example, the second center protrusion CAc may be spaced apart from the first word line WL1 with the device isolation pattern STI (e.g., the first device isolation pattern STI1) interposed therebetween.

Since the first and second center protrusions CAb and CAc protrude from both side surfaces of the center portion CAa, respectively, a profile of each of both side surfaces of the center active portion CA may have an uneven shape. For example, one side surface of the center active portion CA may be recessed toward the inside of the center active portion CA in a region adjacent to the second word line WL2. In addition, another side surface of the center active portion CA may be recessed toward the inside of the center active portion CA in a region adjacent to the first word line WL1. A length of the center portion CAa in the first direction D1 may be greater than a length of the first center protrusion CAb in the first direction D1 and a length of the second center protrusion CAc in the first direction D1. For example, the center portion CAa, the first center protrusion CAb and the second center protrusion CAc may be connected to each other without interfaces therebetween, but example embodiments of inventive concepts are not limited thereto.

The first edge active portion EA1 may include a first edge portion E1a, a first round portion E1b, and a first edge protrusion E1c. The first edge portion E1a may extend along the opposite direction to the first direction D1. The first round portion E1b may surround an end portion of the first edge portion E1a. The first edge protrusion E1c may protrude from one side surface of the first edge portion E1a. The first edge protrusion E1c may extend along the opposite direction to the first direction D1 on the one side surface of the first edge portion E1a. The device isolation pattern STI may be disposed between the first round portion E1b and the first word line WL1 and between the first round portion E1b and the first edge protrusion E1c. For example, the first device isolation pattern STI1 may be disposed between the first round portion E1b and the first word line WL1, and the second device isolation pattern STI2 may be disposed between the first round portion E1b and the first edge protrusion E1c. The first edge portion E1a, the first round portion E1b and the first edge protrusion E1c may be connected to each other without interfaces therebetween, but example embodiments of inventive concepts are not limited thereto.

The second edge active portion EA2 may include a second edge portion E2a, a second round portion E2b, and a second edge protrusion E2c. The second edge portion E2a may extend along the first direction D1. The second round portion E2b may surround an end portion of the second edge portion E2a. The second edge protrusion E2c may protrude from one side surface of the second edge portion E2a. The second edge protrusion E2c may extend along the first direction D1 on the one side surface of the second edge portion E2a. The device isolation pattern STI may be disposed between the second round portion E2b and the second word line WL2 and between the second round portion E2b and the second edge protrusion E2c. For example, the first device isolation pattern STI1 may be disposed between the second round portion E2b and the second word line WL2, and the second device isolation pattern STI2 may be disposed between the second round portion E2b and the second edge protrusion E2c. The second edge portion E2a, the second round portion E2b and the second edge protrusion E2c may be connected to each other without interfaces therebetween, but embodiments of inventive concepts are not limited thereto.

Referring to FIGS. 4A and 4B, except for the descriptions related to the word line WL, other features of the lower active pattern ACTb may be the same/similar as corresponding features of the upper active pattern ACTa described with reference to FIGS. 3A and 3B. However, unlike the upper active pattern ACTa, the lower active pattern ACTb may further include a first middle active portion MA1 and a second middle active portion MA2.

The first middle active portion MA1 may be disposed between the center active portion CA and the first edge active portion EA1 to connect them CA and EA1 to each other. The first middle active portion MA1 may be located under the first word line WL1. The first middle active portion MA1 may include a first middle portion M1a, and a first middle protrusion M1b protruding from one side surface of the first middle portion M1a. The first middle portion M1a may connect the center portion CAa to the first edge portion E1a. The first middle protrusion M1b may connect the first center protrusion CAb to the first edge protrusion E1c.

The second middle active portion MA2 may be disposed between the center active portion CA and the second edge active portion EA2 to connect them CA and EA2 to each other. The second middle active portion MA2 may be located under the second word line WL2. The second middle active portion MA2 may include a second middle portion M2a, and a second middle protrusion M2b protruding from one side surface of the second middle portion M2a. The second middle portion M2a may connect the center portion CAa to the second edge portion E2a. The second middle protrusion M2b may connect the second center protrusion CAc to the second edge protrusion E2c.

Referring again to FIGS. 2A to 4B, the protrusions of the active pattern ACT may protrude toward the third device isolation pattern STI3 but may not protrude toward the first device isolation pattern STI1 and the second device isolation pattern STI2. For example, the protrusions of the active pattern ACT may be provided at the wide trench region AT3 but may not be provided at the narrow trench regions AT1 and AT2. Thus, in a cross section taken along the fourth direction D4, a width of the device isolation pattern STI may be changed depending on a position. For example, in a cross-sectional view, a width W1 of the third device isolation pattern STI3 in the fourth direction D4 may be less than a width W2 of the second device isolation pattern STI2 in the fourth direction D4, but example embodiments of inventive concepts are not limited thereto (see FIG. 2B).

A width of the active pattern ACT in the second direction D2 may be changed depending on a position due to the protrusions when viewed in a plan view. For example, a maximum width W3 of the center active portion CA in the second direction D2 may be greater than a maximum width W4 of the first edge active portion EA1 in the second direction D2 and a maximum width W5 of the second edge active portion EA2 in the second direction D2.

According to inventive concepts, the protrusions of the active pattern ACT may be provided at or in the wide trench region AT3. Thus, the bit line contact DC may be more easily connected to the center active portion CA of the active pattern ACT, and the storage node contact BC may be easily connected to the first edge active portion EA1 or the second edge active portion EA2 of the active pattern ACT. As a result, electrical characteristics and reliability of the semiconductor device may be improved.

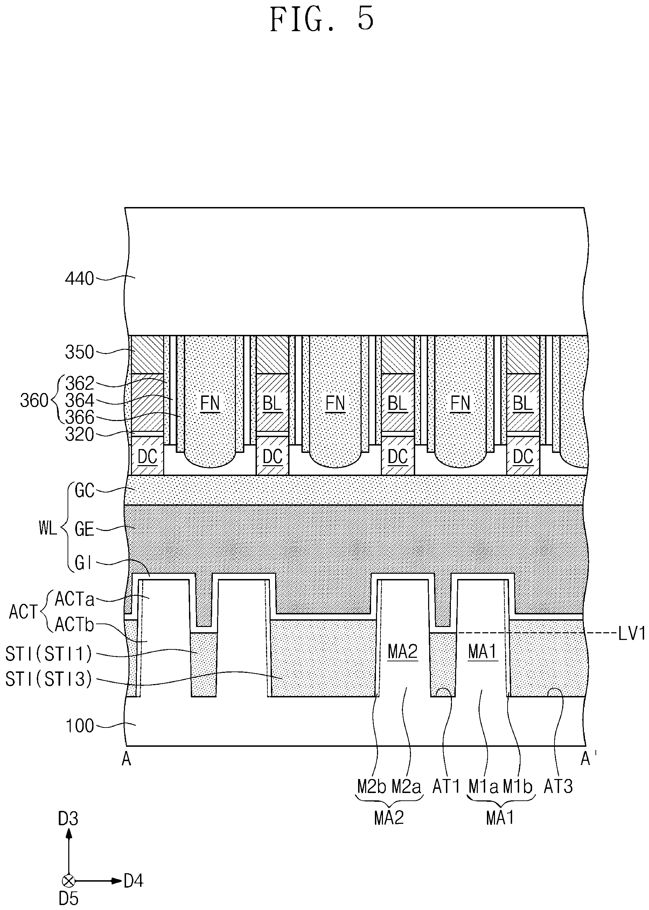

Hereinafter, certain example embodiments of inventive concepts will be described with reference to FIGS. 5 to 7B. In the following example embodiments, the descriptions to the same features as mentioned above will be omitted and differences between the following embodiments and the above embodiments will be mainly described, for the purpose of ease and convenience in explanation.

FIG. 5 is a cross-sectional view corresponding to the line A-A' of FIG. 1 to illustrate a semiconductor device according to some example embodiments of inventive concepts.

Referring to FIG. 5, a bottommost surface of the word line WL may be provided in the narrow trench region AT1 and/or AT2. The word line WL may be deeply provided in the narrow trench region AT1 and/or AT2, and thus a fin structure between the word line WL and the active pattern ACT may be efficiently formed. For example, an area of the active pattern ACT surrounded by the word line WL may be increased. As a result, electrical characteristics and/or reliability of the semiconductor device may be improved.

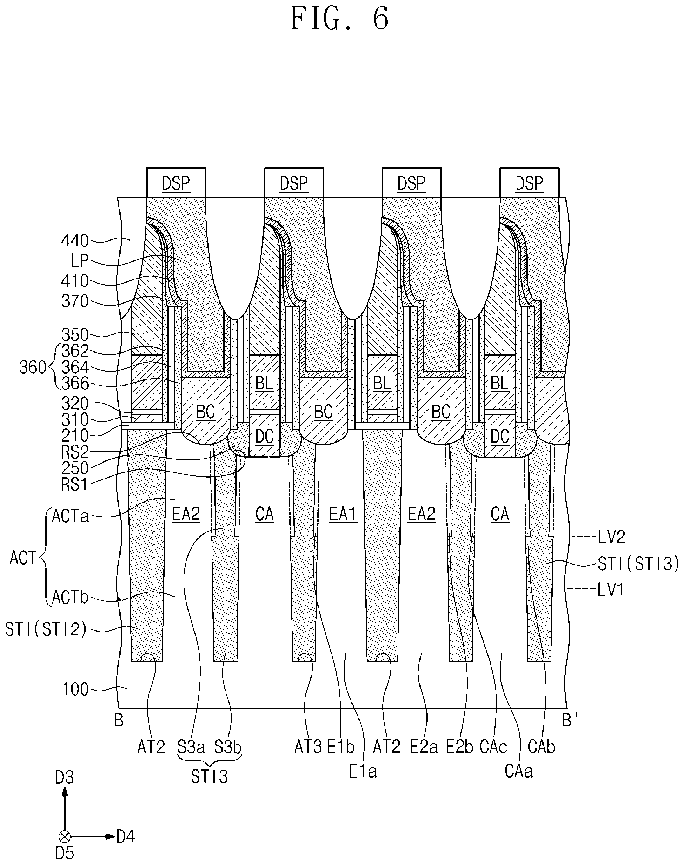

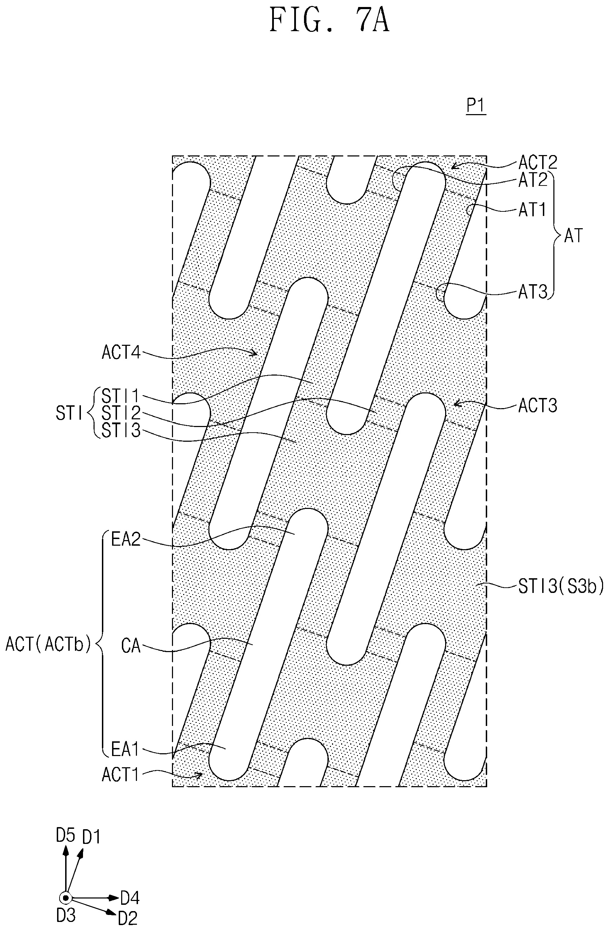

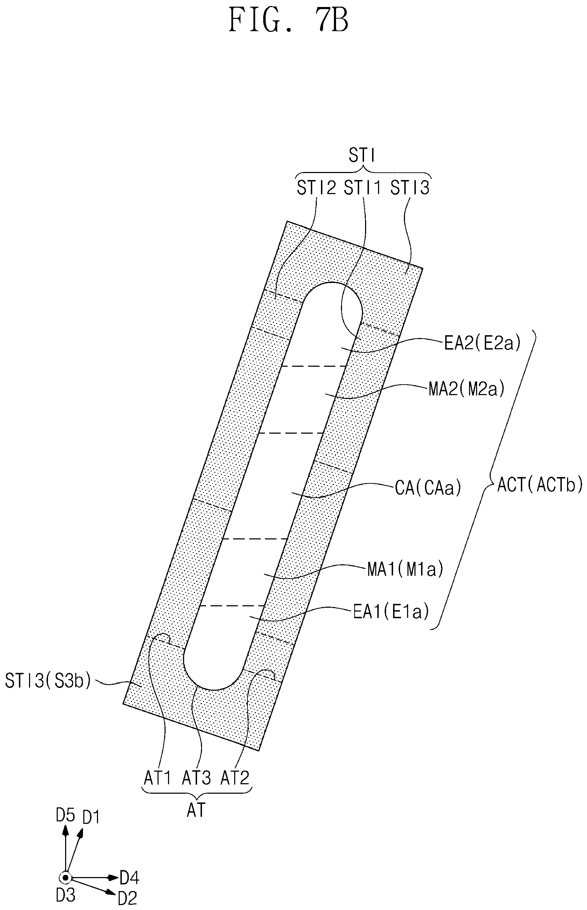

FIG. 6 is a cross-sectional view corresponding to the line B-B' of FIG. 1 to illustrate a semiconductor device according to some example embodiments of inventive concepts. FIG. 7A is an enlarged view corresponding to the region 'P1' of FIG. 1 at a level lower than the first level of FIG. 2A. FIG. 7B is an enlarged view of an active pattern of FIG. 7A.

Referring to FIGS. 6, 7A and 7B, bottommost surfaces of protrusions of the active pattern ACT may be located at a second level LV2. For example, the bottommost surface of the first center protrusion CAb and the bottommost surface of the second center protrusion CAc may be located at the second level LV2. The second level LV2 may be higher than the first level LV1. Thus, the protrusions of the active pattern ACT may be located at a level higher than the first level LV1.

Under the second level LV2, the active pattern ACT may not include the protrusion. For example, under the first level LV1, the lower active pattern ACTb may not include the protrusion. Thus, under the second level LV2, each of both side surfaces of the active pattern ACT may have a straight profile. For example, under the first level LV1, each of both side surfaces of the lower active pattern ACTb may have a straight profile.

Under the second level LV2, the device isolation pattern STI may not protrude toward the active pattern ACT. For example, the first device isolation pattern STI1 and the second device isolation pattern STI2 may protrude toward the inside of the upper active pattern ACTa of the active pattern ACT adjacent thereto but may not protrude toward the inside of the lower active pattern ACTb of the adjacent active pattern ACT.

The third device isolation pattern STI3 may be divided into an upper third device isolation pattern S3a and a lower third device isolation pattern S3b on the basis of the second level LV2. In a cross-sectional view, a side surface of the third device isolation pattern STI3 may have a discontinuous profile as a height in the third direction D3 increases. For example, the side surface of the third device isolation pattern STI3 may have a discontinuous profile between the upper third device isolation pattern S3a and the lower third device isolation pattern S3b. Thus, a width (e.g., a width in the fourth direction D4) of the third device isolation pattern STI3 may also be discontinuously changed between the upper third device isolation pattern S3a and the lower third device isolation pattern S3b.

In a cross-sectional view, a side surface of the center active portion CA may have a discontinuous profile as a height in the third direction D3 increases. For example, each of both side surfaces of the center active portion CA may have a discontinuous profile at the second level LV2. Thus, a width (e.g., a width in the fourth direction D4) of the center active portion CA may also be discontinuously changed at the second level LV2.

In a cross-sectional view, each of one side surface of the first edge active portion EA1 and one side surface of the second edge active portion EA2 may have a discontinuous profile as a height in the third direction D3 increases. For example, the one side surface of the first edge active portion EA1 and the one side surface of the second edge active portion EA2 may have discontinuous profiles at the second level LV2. Thus, a width (e.g., a width in the fourth direction D4) of each of the first and second edge active portions EA1 and EA2 may also be discontinuously changed at the second level LV2.

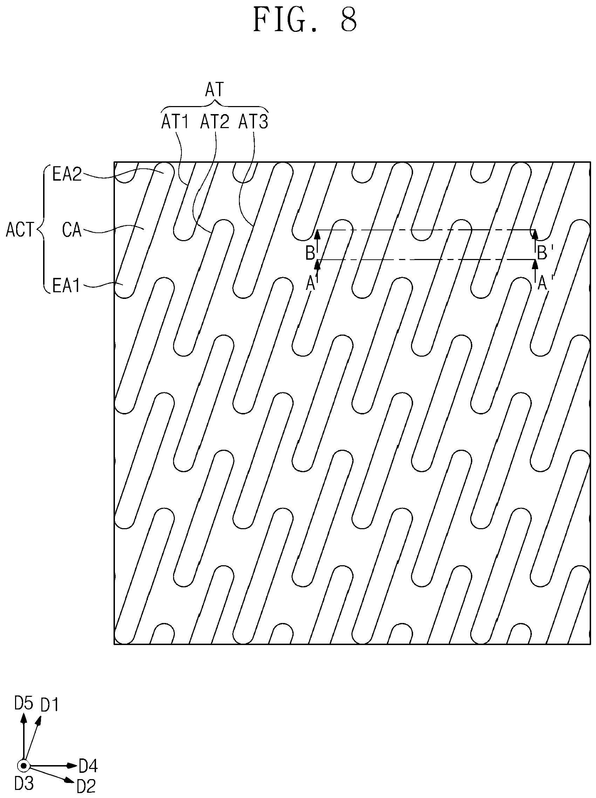

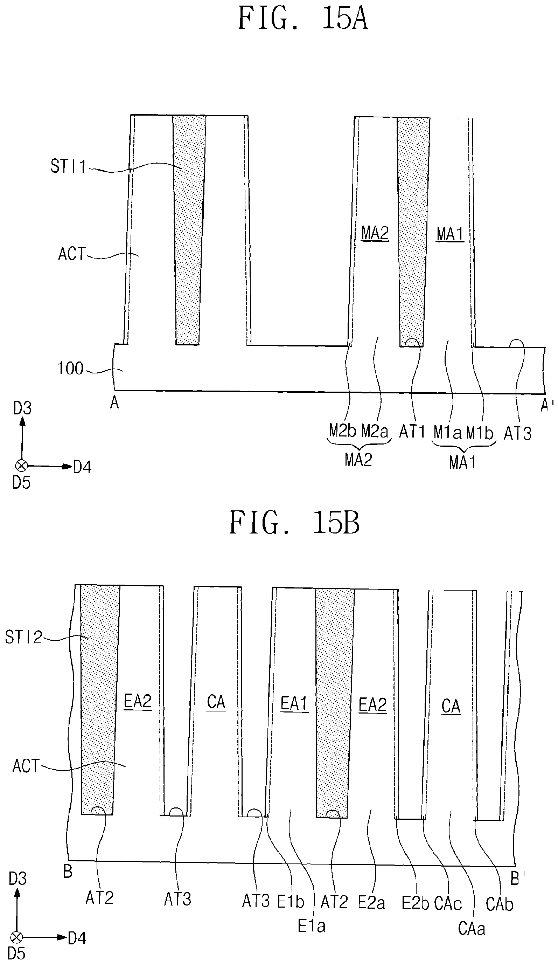

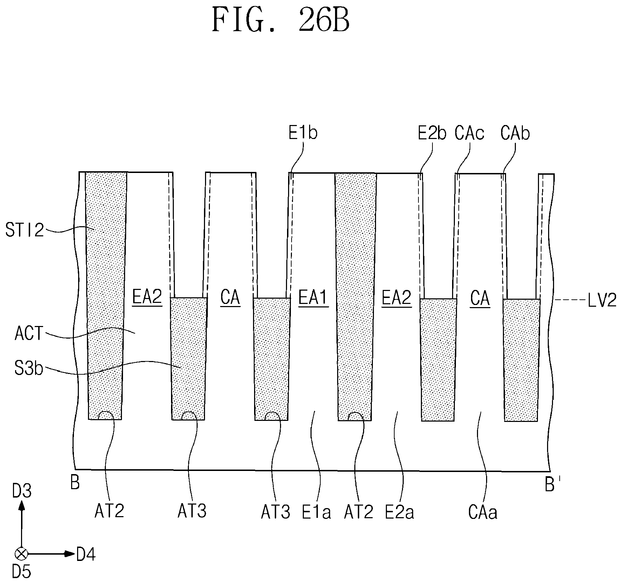

Hereinafter, methods of manufacturing semiconductor devices according to some example embodiments of inventive concepts will be described with reference to FIGS. 8 to 26B. The descriptions to the same features as mentioned above will be omitted for the purpose of ease and convenience in explanation.

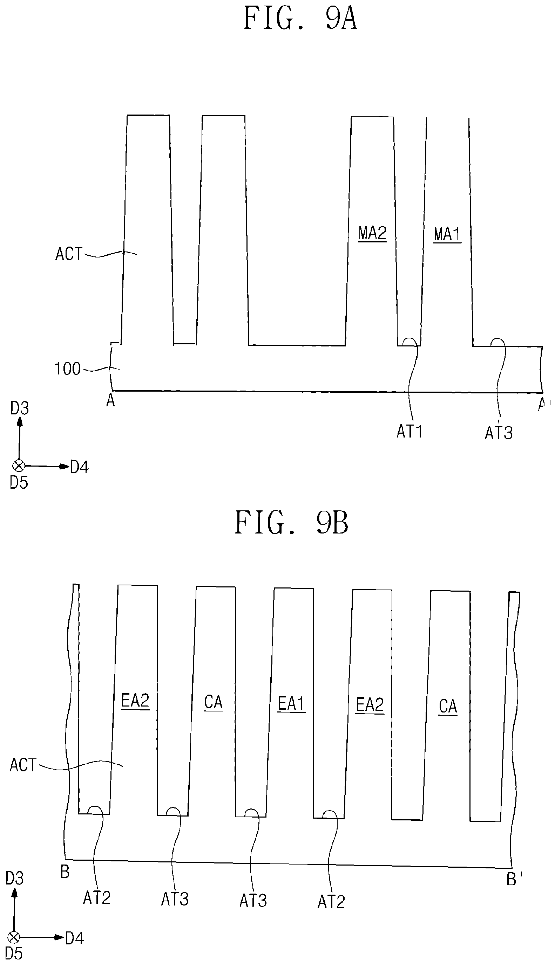

FIGS. 8 to 19B are views illustrating a method of manufacturing a semiconductor device according some example embodiments of inventive concepts. More particularly, FIGS. 8, 10, 12, 14, 16 and 18 are plan views illustrating a method of manufacturing a semiconductor device according to some example embodiments of inventive concepts. FIGS. 9A, 11A, 13A, 15A, 17A and 19A are cross-sectional views taken along lines A-A' of FIGS. 8, 10, 12, 14, 16 and 18, respectively. FIGS. 9B, 11B, 13B, 15B, 17B and 19B are cross-sectional views taken along lines B-B' of FIGS. 8, 10, 12, 14, 16 and 18, respectively. Hereinafter, a method of manufacturing the semiconductor device of FIGS. 1 to 4B will be described with reference to FIGS. 8 to 19B.

Referring to FIGS. 8 to 9B, a substrate 100 may be prepared. A removal process may be performed on the substrate 100 to form active patterns ACT and an active trench region AT. The active trench region AT may include a first narrow trench region AT1, a second narrow trench region AT2, and a wide trench region AT3. Each of the first and second narrow trench regions AT1 and AT2 may be formed between adjacent active patterns ACT relatively close to each other, and the wide trench region AT3 may be formed between adjacent active patterns ACT relatively far away from each other. In some example embodiments, a depth of each of the first and second narrow trench regions AT 1 and AT2 may be different from a depth of the wide trench region AT3, but embodiments of inventive concepts are not limited thereto.

The removal process may include forming mask patterns on the substrate 100 by using an exposure process, and etching the substrate 100 using the mask patterns as etch masks, e.g., using a dry etching process. In some example embodiments, the exposure process and the etching process may be alternately repeated a plurality of times. In some example embodiments, the exposure process may be an exposure process using extreme ultraviolet (EUV) light; however, example embodiments are not limited thereto.

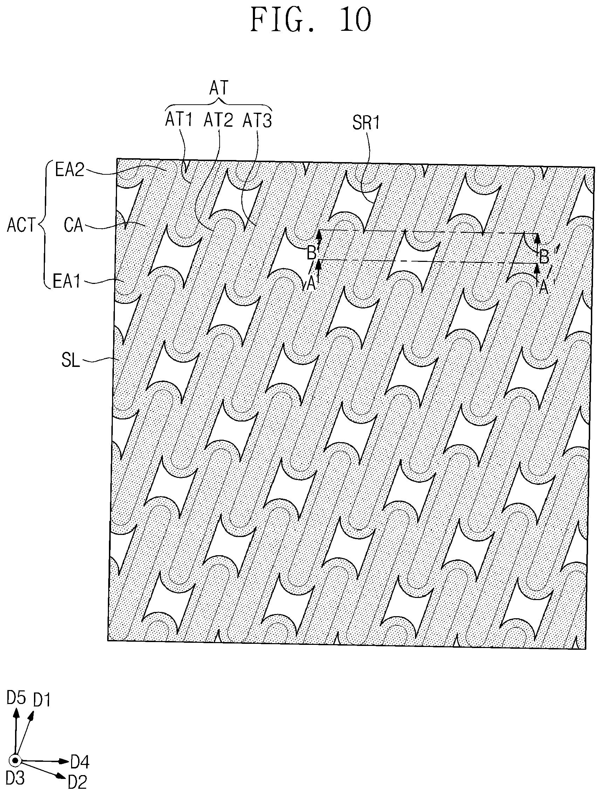

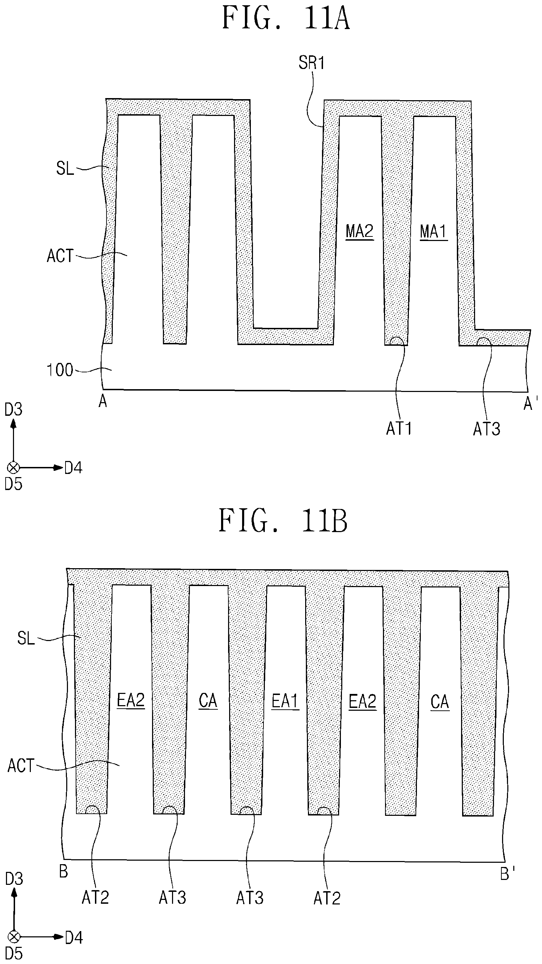

Referring to FIGS. 10 to 11B, a sacrificial layer SL may be formed on an entire top surface of the substrate 100. The sacrificial layer SL may cover an inner surface of the active trench region AT. For example, the sacrificial layer SL may completely fill the first and second narrow trench regions AT1 and AT2. For example, the sacrificial layer SL may conformally cover an inner surface of the wide trench region AT3. For example, the sacrificial layer SL may also cover a top surface of the active pattern ACT.

The formation of the sacrificial layer SL may include performing one or more of a physical vapor deposition (PVD) process, a chemical vapor deposition (CVD) process or an atomic layer deposition (ALD) process. The sacrificial layer SL may include at least one of SiO₂, Si₃N₄, Al₂O₃, La₂O₃, AlN, or SiON.

A first sacrificial recess region SR1 may be formed by the formation process of the sacrificial layer SL. The first sacrificial recess region SR1 may be defined as a recess region surrounded by the sacrificial layer SL. For example, the first sacrificial recess region SR1 may be a region surrounded by the sacrificial layer SL in the wide trench region AT3. The first sacrificial recess region SR1 may be provided in plurality. For example, the first sacrificial recess regions SR1 may be formed in the wide trench regions AT3, respectively.

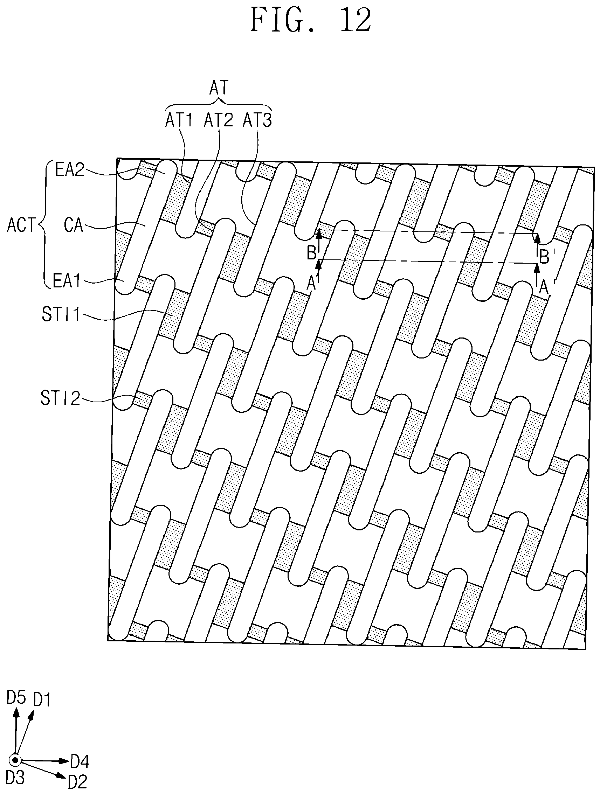

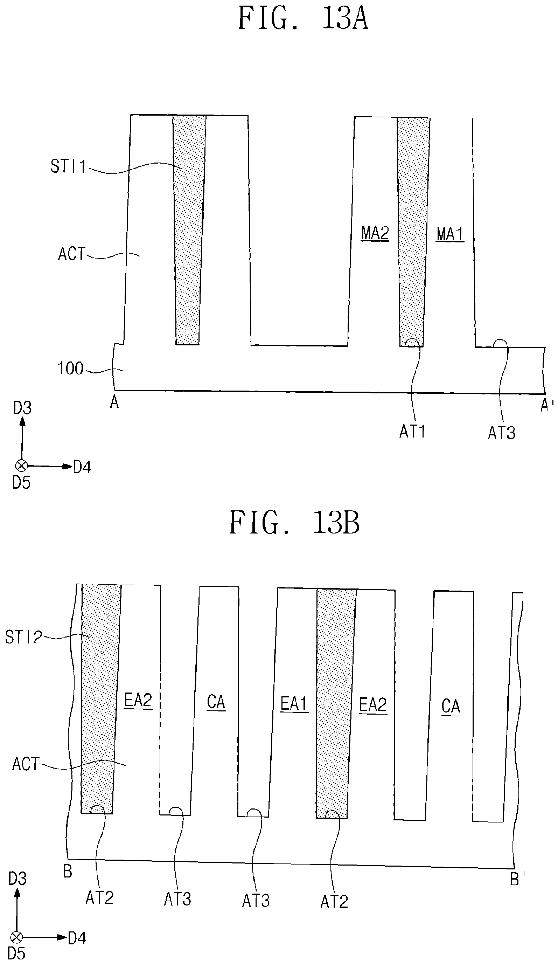

Referring to FIGS. 12 to 13B, a removal process may be performed on the sacrificial layer SL. The removal process may include performing a wet etching process on the sacrificial layer SL. The sacrificial layer SL on the top surface of the active pattern ACT may be removed by the wet etching process. In addition, an etching solution may be provided into the first sacrificial recess region SR1 to remove the sacrificial layer SL surrounding the first sacrificial recess region SR1. For example, the sacrificial layer SL in the wide trench region AT3 may be removed, and a portion of the active pattern ACT, which forms the inner surface of the wide trench region AT3, may be exposed to the outside.

Even though the removal process is performed, portions of the sacrificial layer SL may remain in the first and second narrow trench regions AT1 and AT2. More particularly, the etching solution may not be sufficiently provided into the first and second narrow trench regions AT1 and AT2 having relatively narrow widths, and thus the sacrificial layer SL in the first and second narrow trench regions AT1 and AT2 may not be removed. The sacrificial layer SL remaining in the first narrow trench region AT1 may be defined as a first device isolation pattern STI1. The sacrificial layer SL remaining in the second narrow trench region AT2 may be defined as a second device isolation pattern STI2.

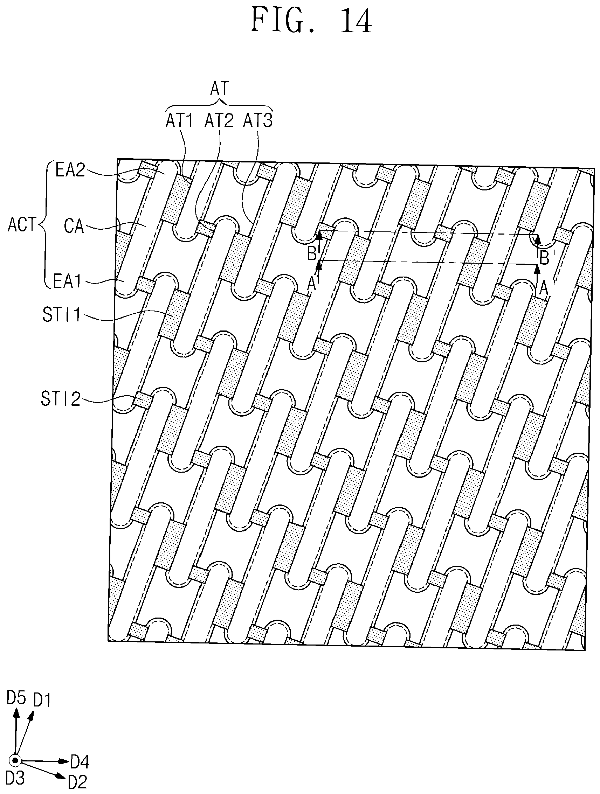

Referring to FIGS. 14 to 15B, protrusions of the active pattern ACT may be formed. The protrusions of the active pattern ACT may be formed on the active pattern ACT exposed in the wide trench region AT3. For example, the formation of the protrusions of the active pattern ACT may include performing a selective epitaxial growth (SEG) process on the active pattern ACT exposed in the wide trench region AT3. Alternatively or additionally, the formation of the protrusions of the active pattern ACT may include depositing a silicon layer conformally covering an entire surface of the substrate 100, and removing the silicon layer provided on the first device isolation pattern STI1 and the second device isolation pattern STI2. However, example embodiments of inventive concepts are not limited thereto, and in certain example embodiments, the protrusions of the active pattern ACT may be formed on the active pattern ACT exposed in the wide trench region AT3 by at least one of other various methods.

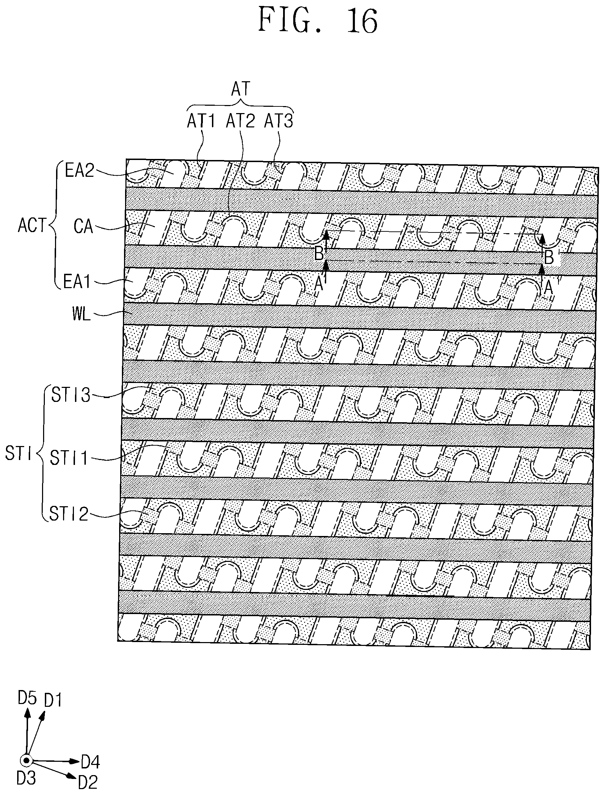

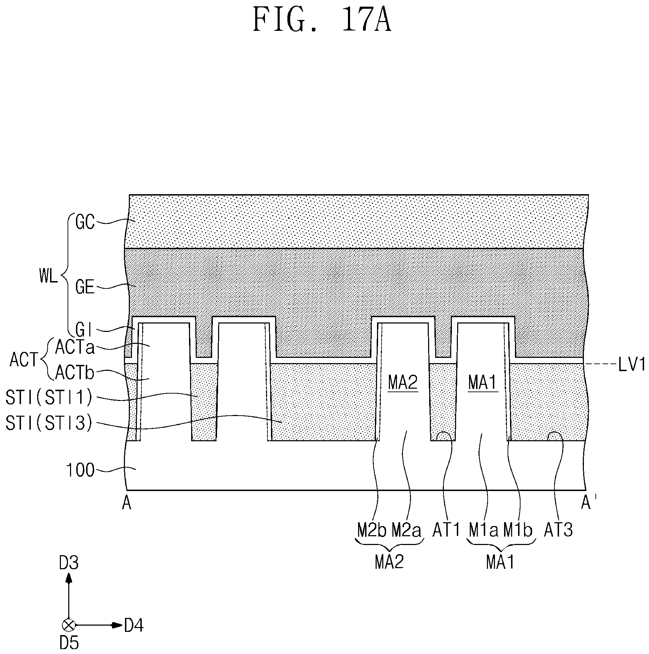

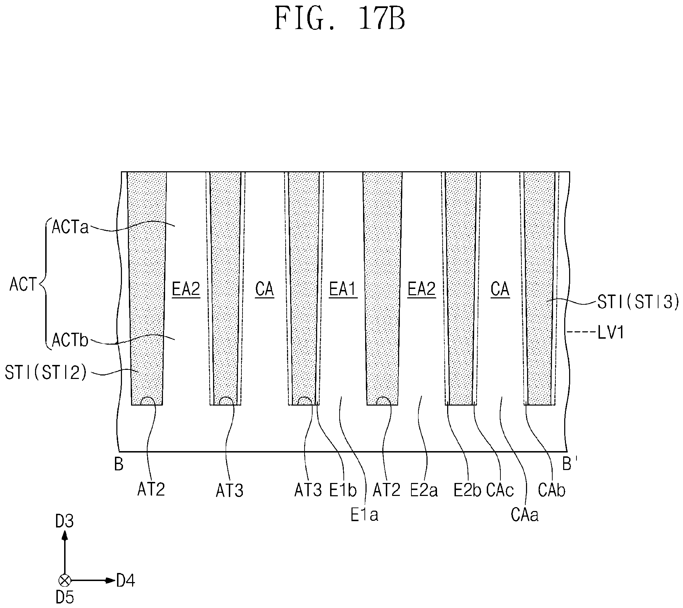

Referring to FIGS. 16 to 17B, a third device isolation pattern STI3 may be formed in the wide trench region AT3. For example, the third device isolation pattern STI3 may be formed to fill the wide trench region AT3. For example, the formation of the third device isolation pattern STI3 may include oxidizing (e.g. thermally oxidizing or growing) portions of the protrusions of the active pattern ACT, but example embodiments of inventive concepts are not limited thereto. In certain example embodiments, the formation of the third device isolation pattern STI3 may further include performing one or more of a physical vapor deposition (PVD) process, a chemical vapor deposition (CVD) process or an atomic layer deposition (ALD) process.

A word line WL may be formed to intersect the active pattern ACT and the device isolation pattern STI (e.g., the first and third device isolation patterns STI1 and STI3). The formation of the word line WL may include forming a mask pattern on the active pattern ACT and the device isolation pattern STI, performing an anisotropic etching process such as a dry etching process using the mask pattern as an etch mask to form a word line trench, and filling the word line trench with the word line WL. A plurality of the word lines WL may extend along the fourth direction D4 in the active patterns ACT and may be spaced apart from each other in the fifth direction D5. For example, the filling of the word line trench with the word line WL may include conformally depositing a gate dielectric pattern GI on an inner surface of the word line trench, filling the word line trench with a conductive layer, performing an etch-back process and/or a polishing process on the conductive layer to form a gate electrode GE, and forming a gate capping pattern GC filling a remaining portion of the word line trench on the gate electrode GE.

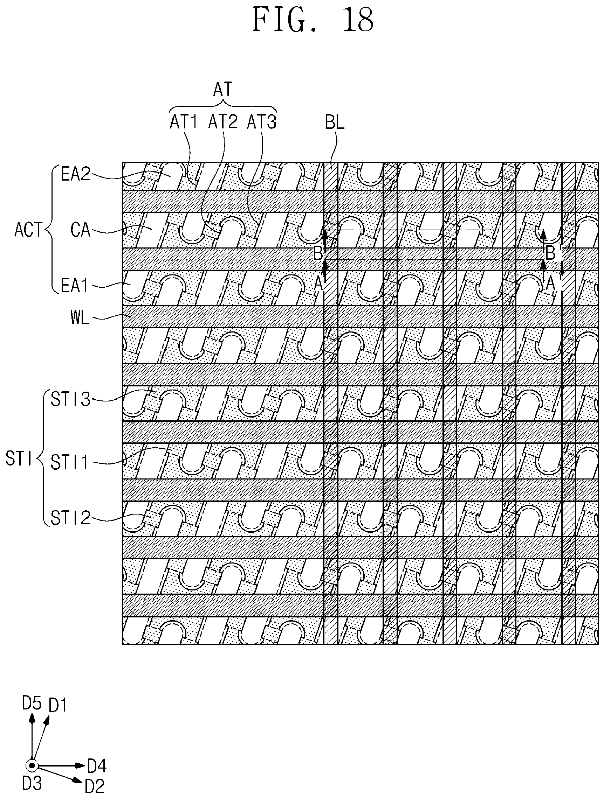

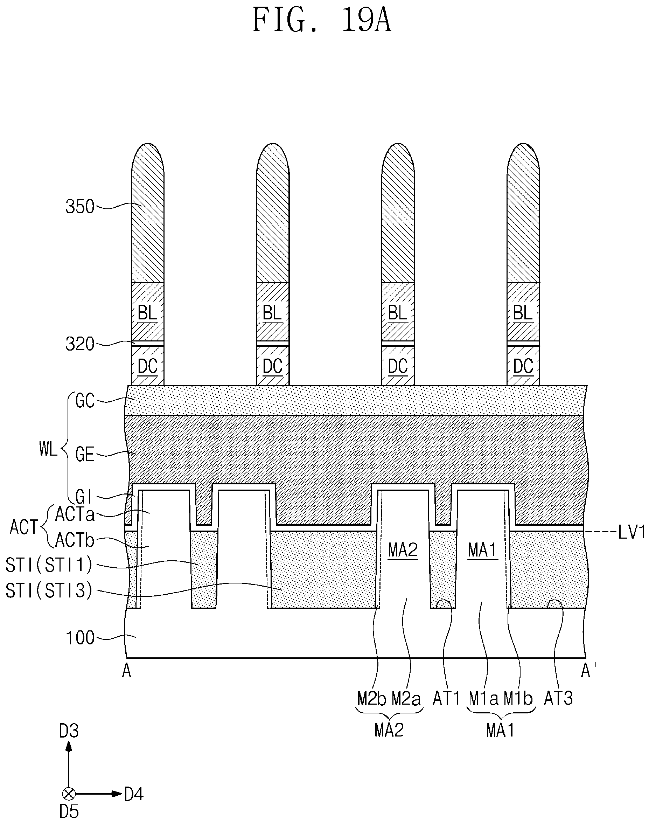

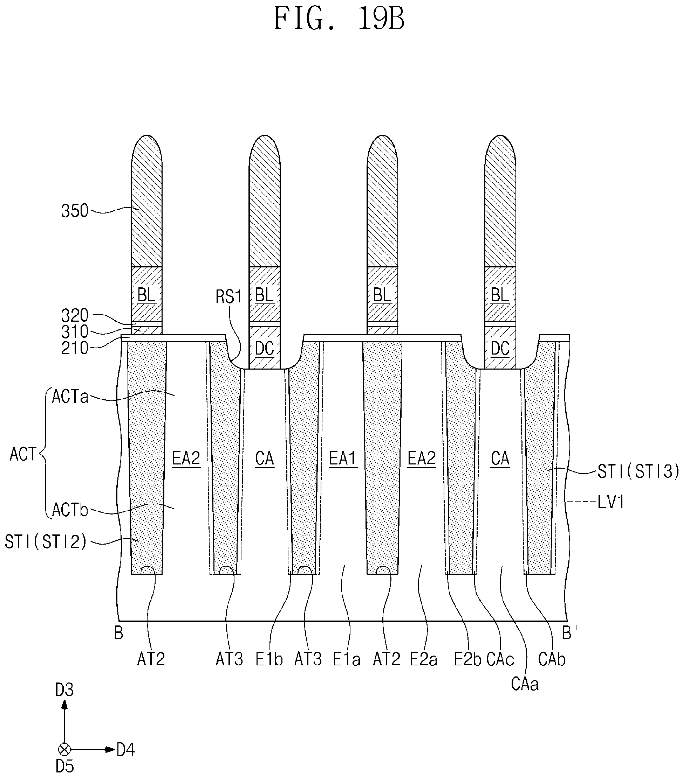

Referring to FIGS. 18 to 19B, a buffer layer (not shown) and a polysilicon layer (not shown) may be formed to cover the active pattern ACT and the device isolation pattern STI, and a first recess region RS1 may be formed on each of the active patterns ACT and the device isolation pattern STI adjacent thereto. When the first recess region RS1 is formed, the buffer layer and the polysilicon layer may be partially removed to form a buffer pattern 210 and a polysilicon pattern 310.

A bit line contact DC, a first ohmic pattern 320, a bit line BL and a bit line capping pattern 350 may be formed on the first recess region RS1. The formation of the bit line contact DC, the first ohmic pattern 320, the bit line BL and the bit line capping pattern 350 may include forming a bit line contact layer (not shown) filling the first recess region RS1, sequentially forming a first ohmic layer (not shown), a bit line layer (not shown) and a bit line capping layer (not shown) on the bit line contact layer, and etching the bit line contact layer, the first ohmic layer, the bit line layer and the bit line capping layer to form the bit line contact DC, the first ohmic pattern 320, the bit line BL and the bit line capping pattern 350. At this time, a portion of the polysilicon pattern 310 may be further etched. In this process, a portion of an inner surface of the first recess region RS1 may be exposed again to the outside. In the process of forming the bit line BL, a first barrier pattern (not shown) may be additionally formed between the bit line BL and the bit line contact DC and between the bit line BL and the polysilicon pattern 310.

Referring again to FIGS. 1 to 2B, a filling insulation pattern 250 may be formed to fill a remaining portion of the first recess region RS1. A bit line spacer 360 may be formed to cover a side surface of the bit line BL and a side surface of the bit line capping pattern 350. The formation of the bit line spacer 360 may include sequentially forming a first spacer 362, a second spacer 364 and a third spacer 366, which conformally cover the side surface of the bit line BL and the side surface of the bit line capping pattern 350.

Storage node contacts BC and fence patterns FN may be formed between the bit lines BL adjacent to each other. The storage node contacts BC and the fence patterns FN may be alternately arranged in the fifth direction D5. Before the formation of the storage node contacts BC, a second recess region RS2 may be formed on each of the first and second edge active portions EA1 and EA2 of the active pattern ACT. Each of the storage node contacts BC may fill the second recess region RS2 and may be electrically connected to a corresponding one of the first and second edge active portions EA1 and EA2 in the second recess region RS2. The fence patterns FN may be formed to vertically overlap with the word lines WL. For example, the storage node contacts BC may be first formed, and then, the fence patterns FN may be formed between the storage node contacts BC. Alternatively, the fence patterns FN may be first formed, and then, the storage node contacts BC may be formed between the fence patterns FN.

In the process of forming the storage node contacts BC, a portion of an upper portion of the bit line spacer 360 may be removed. Thus, a capping spacer 370 may further be formed at a position from which the portion of the bit line spacer 360 is removed. Thereafter, a second barrier pattern 410 may be formed to conformally cover the bit line spacer 360, the capping spacer 370 and the storage node contacts BC.

Landing pads LP may be formed on the storage node contacts BC. The formation of the landing pads LP may include sequentially forming a landing pad layer (not shown) and mask patterns (not shown) which cover top surfaces of the storage node contacts BC, and dividing the landing pad layer into a plurality of the landing pads LP by an anisotropic etching process using the mask patterns as etch masks. A portion of the second barrier pattern 410, a portion of the bit line spacer 360 and a portion of the bit line capping pattern 350 may be etched by the anisotropic etching process, and they 410, 360 and 350 may be exposed to the outside. An upper portion of the landing pad LP may be shifted from the storage node contact BC in the fourth direction D4.

In some example embodiments, the second spacer 364 may be exposed by the anisotropic etching process of the landing pad layer. An etching process may further be performed on the second spacer 364 through the exposed portion of the second spacer 364, and finally, the second spacer 364 may include an air gap. However, example embodiments of inventive concepts are not limited thereto.

Thereafter, a filling pattern 440 may be formed to cover the exposed portions and to surround each of the landing pads LP in a plan view, and a data storage pattern DSP may be formed on each of the landing pads LP.

According to inventive concepts, the protrusions of the active pattern ACT may not be provided in the first and second narrow trench regions AT1 and AT2. Thus, it may be possible to reduce stress applied to the active pattern ACT by the protrusions of the active pattern ACT, and it is possible to prevent process failure such as a bending phenomenon of the active pattern ACT by the stress. As a result, productivity of the semiconductor device may be improved.

Alternatively or additionally, according to some example embodiments, portions of the protrusions of the active pattern ACT may include polysilicon. In the case in which the active pattern ACT includes polysilicon, a leakage current caused by a poly-crystalline property may be increased. According to inventive concepts, the protrusions of the active pattern ACT may be formed in a local region, and thus a leakage current caused by polysilicon may be minimized. As a result, electrical characteristics and reliability of the semiconductor device may be improved.

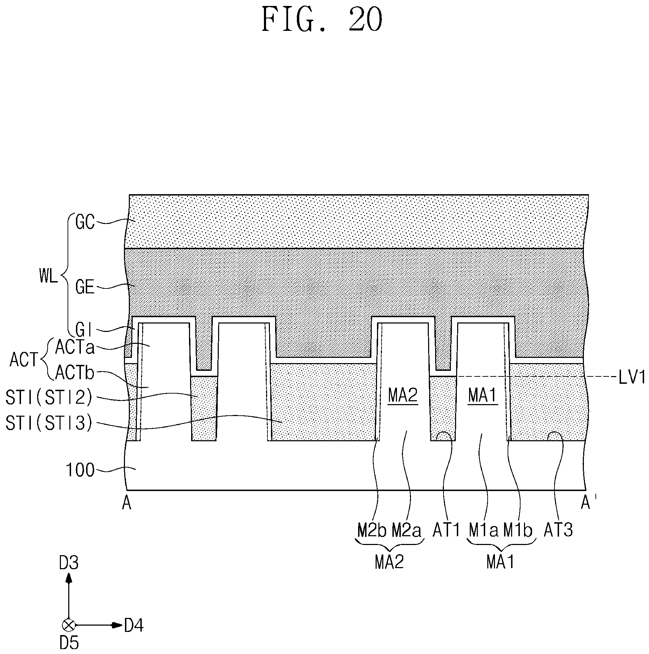

FIG. 20 is a view illustrating a method of manufacturing a semiconductor device according to some example embodiments of inventive concepts. Hereinafter, a method of manufacturing the semiconductor device of FIG. 5 will be described with reference to FIG. 20.

Referring to FIG. 20, in the formation of the word line WL described with reference to FIG. 17A, a bottommost surface of the word line WL may be formed in the narrow trench region AT1 and/or AT2. The protrusions of the active pattern ACT may not be formed in the narrow trench region AT1 and/or AT2, and thus a width of the narrow trench region AT1 and/or AT2 may be a certain value or more. Therefore, when the word line trench is formed, the anisotropic etching process may be effectively performed in the narrow trench region AT1 and/or AT2. As a result, the word line trench may be deeply formed in the narrow trench region AT1 and/or AT2, and the bottommost surface of the word line WL may be formed in the narrow trench region AT1 and/or AT2.

Thereafter, the semiconductor device described with reference to FIG. 5 may be manufactured using the aforementioned method of manufacturing the semiconductor device.

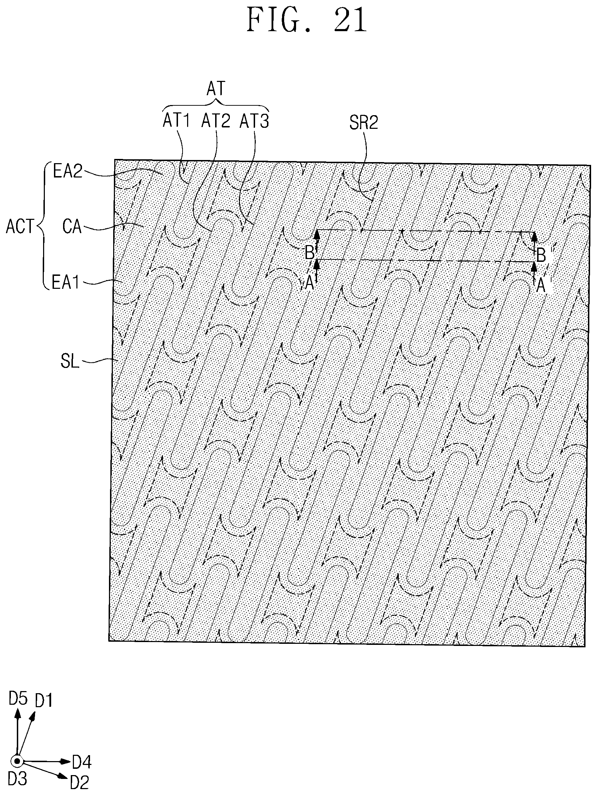

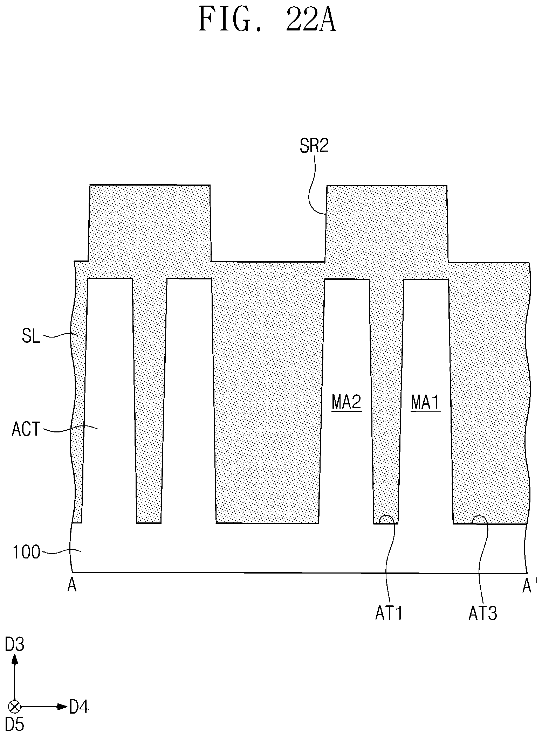

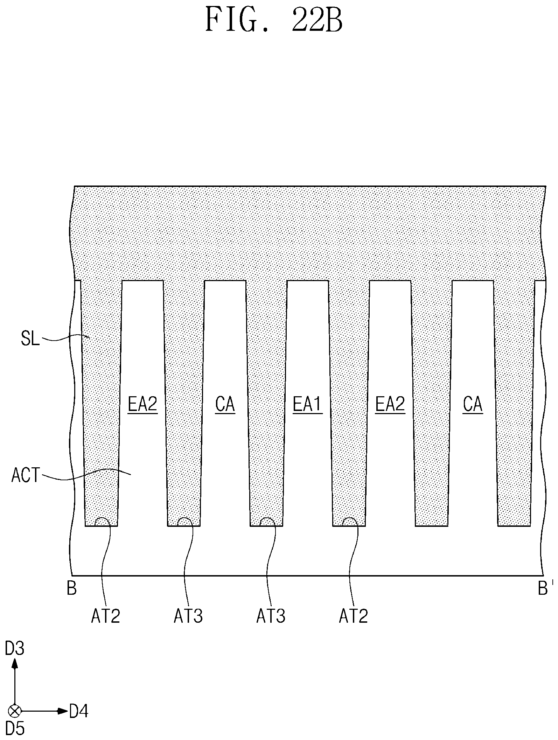

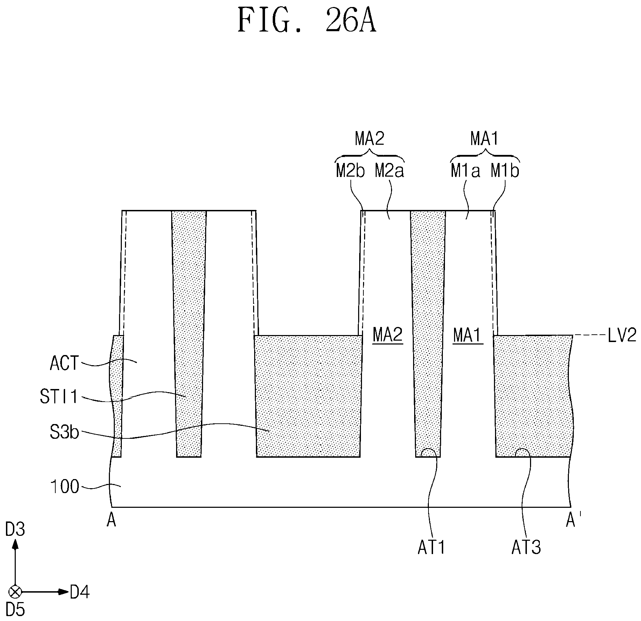

FIGS. 21 to 26B are views illustrating a method of manufacturing a semiconductor device according to some example embodiments of inventive concepts. More particularly, FIGS. 21, 23 and 25 are plan views illustrating a method of manufacturing a semiconductor device according to some example embodiments of inventive concepts. FIGS. 22A, 24A and 26A are cross-sectional views taken along lines A-A' of FIGS. 21, 23 and 25, respectively. FIGS. 22B, 24B and 26B are cross-sectional views taken along lines B-B' of FIGS. 21, 23 and 25, respectively. Hereinafter, a method of manufacturing the semiconductor device of FIGS. 6 to 7B will be described with reference to FIGS. 21 to 26B.

Referring to FIGS. 21 to 22B, unlike FIGS. 10 to 11B, the sacrificial layer SL may completely fill the wide trench region AT3. The narrow trench region AT1 and AT2 may be filled with the sacrificial layer SL prior to the wide trench region AT3. Thus, the sacrificial layer SL may be relatively thickly formed on the active pattern ACT and the narrow trench region AT1 and AT2 while filling the wide trench region AT3. As a result, a second sacrificial recess region SR2 may be formed on the wide trench region AT3. For example, the second sacrificial recess region SR2 may be formed above the wide trench region AT3. The second sacrificial recess region SR2 may be surrounded by the sacrificial layer SL on the active pattern ACT and the narrow trench region AT1 and AT2.

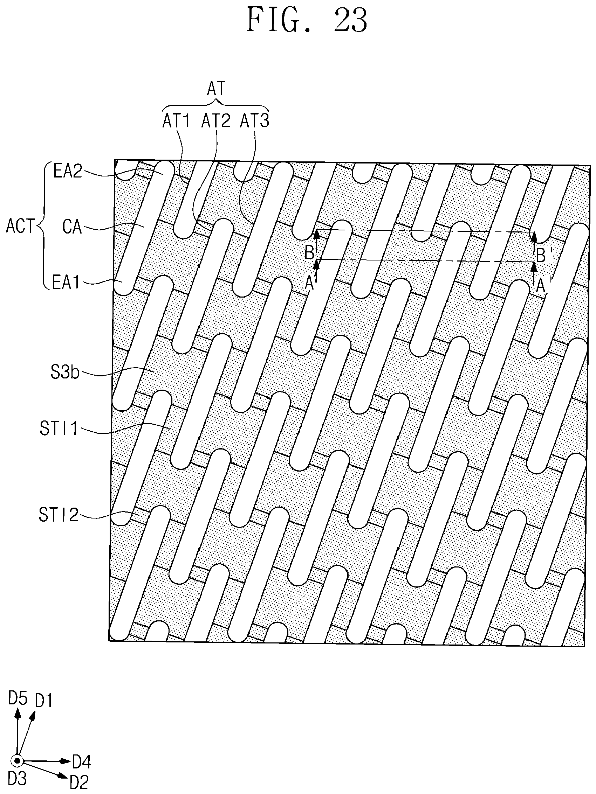

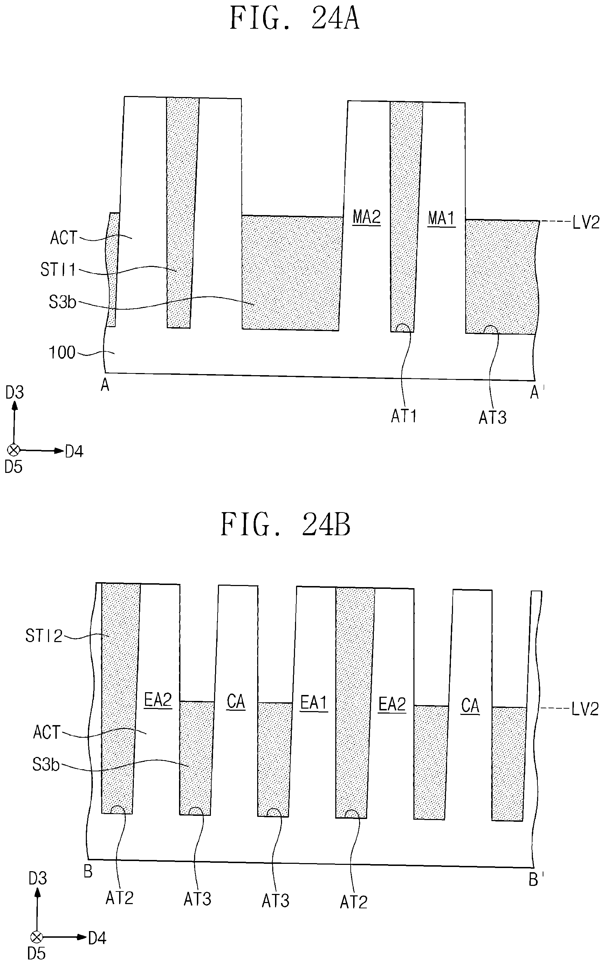

Referring to FIGS. 23 to 24B, a removal process may be performed on the sacrificial layer SL. The removal process may include removing an upper portion of the sacrificial layer SL, and performing a wet etching process on the sacrificial layer SL.

For example, the removing of the upper portion of the sacrificial layer SL may include performing an etch-back process on the sacrificial layer SL. Since the upper portion of the sacrificial layer SL is removed, the second sacrificial recess region SR2 may be transferred downward (e.g., into the wide trench region AT3). After the removal of the upper portion of the sacrificial layer SL, a portion of the sacrificial layer SL may remain in a lower region of the wide trench region AT3.

In the wet etching process performed on the sacrificial layer SL, an etching solution may be provided into the second sacrificial recess region SR2 to remove the sacrificial layer SL surrounding the second sacrificial recess region SR2. Thus, a portion of the active pattern ACT, which forms an inner side surface of the wide trench region AT3, may be exposed to the outside. For example, an upper portion of the active pattern ACT, which forms the inner side surface of the wide trench region AT3, may be exposed to the outside. After the wet etching process, a portion of the sacrificial layer SL may remain in a lower region of the wide trench region AT3. The sacrificial layer SL remaining in the wide trench region AT3 may be defined as a lower third device isolation pattern S3b.

Even though the removal process is performed, the sacrificial layer SL may remain in the first and second narrow trench regions AT1 and AT2. For example, even though the removal process is performed, the sacrificial layer SL may completely fill the first and second narrow trench regions AT1 and AT2. The sacrificial layer SL remaining in the first narrow trench region AT1 may be defined as a first device isolation pattern STI1. The sacrificial layer SL remaining in the second narrow trench region AT2 may be defined as a second device isolation pattern STI2.

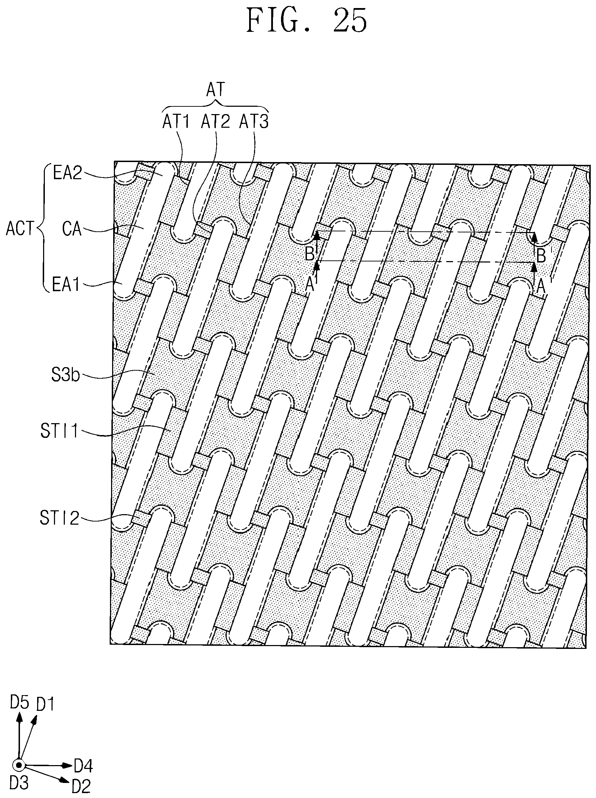

Referring to FIGS. 25 to 26B, protrusions of the active pattern ACT may be formed. The protrusions of the active pattern ACT may be formed on the active pattern ACT exposed in the wide trench region AT3. For example, the protrusions of the active pattern ACT may be formed on the upper portion of the active pattern ACT, which is exposed in the wide trench region AT3. Since the protrusions of the active pattern ACT are formed, both side surfaces of the center active portion CA, one side surface of the first edge active portion EA1 and one side surface of the second edge active portion EA2 may have discontinuous profiles.

Referring again to FIGS. 6 to 7B, a third device isolation pattern STI3 may be formed in the wide trench region AT3. The formation of the third device isolation pattern STI3 may include forming an upper third device isolation pattern S3a in an upper region of the wide trench region AT3. The third device isolation pattern STI3 may include the upper third device isolation pattern S3a and the lower third device isolation pattern S3b.

Thereafter, the semiconductor device described with reference to FIGS. 6 to 7B may be manufactured using the aforementioned method of manufacturing the semiconductor device.

According to inventive concepts, the protrusions of the active pattern may be provided in the wide trench region. Thus, the bit line contact and the storage node contact may be more easily connected to the active pattern. Alternatively or additionally, the protrusions of the active pattern may not be provided in the narrow trench region. Thus, process failure (e.g., the bending phenomenon of the active pattern) may be prevented or reduced in likelihood of occurrence, and/or a leakage current may be minimized or reduced. As a result, the electrical characteristics, the reliability and/or the productivity of the semiconductor device may be improved.

Alternatively or additionally, according to inventive concepts, the fin structure between the word line and the active pattern may be more efficiently formed. As a result, the electrical characteristics and/or reliability of the semiconductor device may be improved.

While the embodiments of inventive concepts have been particularly shown and described, it will be understood by one of ordinary skill in the art that variations in form and detail may be made therein without departing from the spirit and scope of the attached claims. Additionally example embodiments are not necessarily mutually exclusive. For example, some example embodiments may include one or more features described with reference to one or more figures, and may also include one or more other features described with reference to one or more other figures.

## Claims

1. A semiconductor device comprising:
an active pattern extending along a first direction; and
a first word line and a second word line which intersect the active pattern,
wherein the active pattern comprises a center active portion between the first word line and the second word line,
wherein the center active portion comprises,
a center portion extending from the first word line to the second word line,
a first center protrusion protruding from one side surface of the center portion in a second direction intersecting the first direction, and
a second center protrusion protruding from another side surface of the center portion in an opposite direction to the second direction,
wherein the first center protrusion extends from the first word line along the first direction, and
wherein the second center protrusion extends from the second word line along an opposite direction to the first direction.

2. The semiconductor device of claim 1, wherein
the first center protrusion is spaced apart from the second word line, and
the second center protrusion is spaced apart from the first word line.

3. The semiconductor device of claim 1, wherein a length of the center portion in the first direction is greater than a length of the first center protrusion in the first direction, and is greater than a length of the second center protrusion in the first direction.

4. The semiconductor device of claim 1, wherein the center portion, the first center protrusion, and the second center protrusion are connected to each other without interfaces therebetween.

5. The semiconductor device of claim 1, further comprising:
a device isolation pattern surrounding the active pattern,
wherein the device isolation pattern protrudes from a side surface of the active pattern toward an inside of the active pattern.

6. The semiconductor device of claim 1, wherein the active pattern further comprises:
a first edge active portion and a second edge active portion, which are spaced apart from each other with the center active portion interposed therebetween, wherein
the first word line is between the center active portion and the first edge active portion,
the second word line is between the center active portion and the second edge active portion,
the first edge active portion comprises a first edge portion, a first round portion surrounding an end portion of the first edge portion, and a first edge protrusion protruding from one side surface of the first edge portion,
the second edge active portion comprises a second edge portion, a second round portion surrounding an end portion of the second edge portion, and
a second edge protrusion protruding from one side surface of the second edge portion.

7. The semiconductor device of claim 6, wherein
the first edge protrusion extends from the first word line along the opposite direction to the first direction, and
the second edge protrusion extends from the second word line along the first direction.

8. The semiconductor device of claim 6, wherein the active pattern further comprises:
a first middle active portion under the first word line and between the center active portion and the first edge active portion; and
a second middle active portion under the second word line and between the center active portion and the second edge active portion.

9. The semiconductor device of claim 8, wherein
the first middle active portion comprises a first middle portion, and a first middle protrusion protruding from one side surface of the first middle portion,
the second middle active portion comprises a second middle portion and a second middle protrusion protruding from one side surface of the second middle portion,
the first middle protrusion connects the first center protrusion and the first edge protrusion, and
the second middle protrusion connects the second center protrusion and the second edge protrusion.

10. The semiconductor device of claim 1, wherein a profile of each of a first and a second side surfaces of the active pattern has an uneven shape.

11. The semiconductor device of claim 1, wherein
a bottommost surface of the first word line and a bottommost surface of the second word line are at a first level,
a bottommost surface of the first center protrusion and a bottommost surface of the second center protrusion are at a second level, and
the second level is above the first level.

12. The semiconductor device of claim 1, wherein
a bottommost surface of the first word line and a bottommost surface of the second word line are at a first level, and
one side surface of the active pattern under the first level has a straight profile.

13. A method of manufacturing a semiconductor device, the method comprising:
etching a substrate to form active patterns extending along a first direction and an active trench region between the active patterns, the active trench region comprising a narrow trench region and a wide trench region;
forming a sacrificial layer covering the active patterns and an inner surface of the active trench region;
removing the sacrificial layer in the wide trench region to expose portions of the active patterns; and
forming protrusions on the exposed portions of the active patterns,
wherein the sacrificial layer completely fills the narrow trench region in the forming of the sacrificial layer.

14. The method of claim 13, wherein a sacrificial recess region defined by the sacrificial layer is formed in the wide trench region in the forming of the sacrificial layer.

15. The method of claim 13, wherein a sacrificial recess region defined by the sacrificial layer is formed on the wide trench region in the forming of the sacrificial layer.
